# EUROPEAN PATENT SPECIFICATION

(11) **EP 4 701 169 B1**
(45) Date of publication and mention of the grant of the patent: **09.12.2026**
(21) Application number: 25742810.2
(22) Date of filing: 07.07.2025
(51) Int. Cl.: H04M 1/02, H05K 1/14, H04M 1/03, G06F 1/16, H05K 1/189

(54) **ELECTRONIC DEVICE HAVING COMPONENT ARRANGEMENT STRUCTURE COMPRISING PCB**
ELEKTRONISCHE VORRICHTUNG MIT KOMPONENTENANORDNUNGSSTRUKTUR MIT LEITERPLATTE
DISPOSITIF ÉLECTRONIQUE AYANT UNE STRUCTURE D'AGENCEMENT DE COMPOSANTS COMPRENANT UNE CARTE DE CIRCUIT IMPRIMÉ

(30) Priority: 08.07.2024 KR 20240089874; 22.08.2024 KR 20240112909
(43) Date of publication of application: 25.02.2026
(73) Proprietor: Samsung Electronics Co., Ltd, Suwon-si, Gyeonggi-do 16677 (KR)
(72) Inventor: JUNG, Kiyoung, Suwon-si, Gyeonggi-do 16677 (KR); CHO, Sujin, Suwon-si, Gyeonggi-do 16677 (KR); CHUN, Woosung, Suwon-si, Gyeonggi-do 16677 (KR)
(74) Representative: Gulde & Partner
(86) International application number: PCT/KR2025/009767
(87) International publication number: WO 2026/014850

(56) References cited:
- WO-A1-2022/139482
- DE-A1- 102011 080 344
- KR-A- 20120 103 219
- KR-A- 20240 007 093
- KR-B1- 102 353 493
- KR-B1- 102 606 454
- US-A1- 2008 007 286

## Description

### [Technical Field]

The disclosure relates to an electronic device including a component arrangement structure including a printed circuit board (PCB).

### [Background Art]

An electronic device may include a PCB and a plurality of components arranged on the PCB.

The above information may be presented as background information only to assist with an understanding of the disclosure. No determination has been made, and no assertion is made, as to whether any of the above might be applicable as prior art with regard to the disclosure.

A prior art of KR20240007093A relates to an electronic device comprising a housing, an antenna, and a circuit board. The housing includes a conductive part and openings for key caps. An opening is defined by the conductive part, non-conductive parts, and the antenna.

Another prior art of US2008007286A1 relates to a testing arrangement where a printed circuit board (PCB 600) has an opening (602). A component (500) is mounted on the primary side of the PCB. An external test probe (230) is designed to pass through the PCB opening to make electrical contact with a pad (520) on the components underside for testing purpose.

### [Disclosure of Invention]

### [Technical Problem]

As an electronic device becomes thinner, it may become difficult to arrange a plurality of components in the electronic device.

Embodiments of the disclosure provide an electronic device that includes a component arrangement structure, including a PCB, capable of securing space efficiency in a restricted internal space of the electronic device when arranging a plurality of components on the PCB.

Various embodiments of the disclosure are provided to address or at least alleviate the above-mentioned problems.

The technical problems to be solved in the disclosure are not limited to those mentioned above, and other technical problems not mentioned can be understood from the description below by a person having ordinary skill in the technical field to which the disclosure belongs.

### [Solution to Problem]

According to embodiments of the disclosure, an electronic device is provided as per the appended claims.

### [Advantageous Effects of Invention]

An electronic device including a component arrangement structure including a PCB according to embodiments of the disclosure can improve the freedom of component design and slimness of the electronic device by allowing a plurality of components to be arranged space-efficiently with respect to the PCB.

In addition, the effects that can be obtained or expected according to various embodiments of the disclosure are directly or implicitly disclosed in the detailed description of the embodiments of the disclosure.

### [Brief Description of Drawings]

The above and other aspects, features, and advantages of specific embodiments of the disclosure will become more apparent from the following detailed description taken in conjunction with the accompanying drawings.
FIG. 1 is a block diagram of an electronic device in a network environment, according to various embodiments of the disclosure.
FIG. 2 is a diagram illustrating appearances of a foldable electronic device in an unfolded state, according to various embodiments of the disclosure.
FIG. 3 is a diagram illustrating appearances of a foldable electronic device in a folded state, according to various embodiments of the disclosure.
FIG. 4 is a cross-sectional view of a foldable electronic device in an unfolded state taken along line D-D' of FIG. 2, according to various embodiments of the disclosure.
FIG. 5 is a diagram illustrating a portion of a foldable electronic device in an unfolded state, according to various embodiments of the disclosure.
FIG. 6 is a diagram illustrating a portion of a foldable electronic device, according to various embodiments of the disclosure.
FIG. 7 is a diagram illustrating a portion of a foldable electronic device, according to various embodiments of the disclosure.
FIG. 8 is a diagram illustrating a portion of a foldable electronic device, according to various embodiments of the disclosure.
FIG. 9 is an exploded perspective view of a portion of a foldable electronic device, according to various embodiments of the disclosure.
FIG. 10 is a cross-sectional view of a portion of a foldable electronic device taken along line FF' of FIG. 6, according to various embodiments of the disclosure.
FIG. 11 is a cross-sectional view of a portion of a foldable electronic device taken along line GG' of FIG. 6, according to various embodiments of the disclosure.
FIG. 12 is a perspective view of a portion of a foldable electronic device, according to various embodiments of the disclosure.

### [Mode for the Invention]

Hereinafter, various embodiments of the disclosure disclosed herein will be described in greater detail with reference to the accompanying drawings.

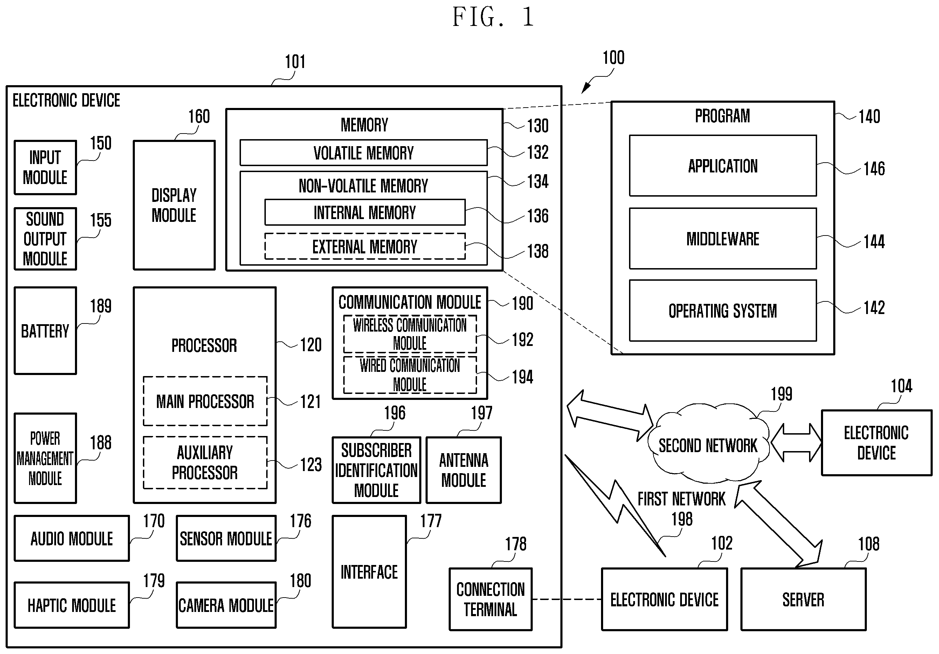

FIG. 1 is a block diagram of an electronic device 101 in a network environment 100 according to various embodiments of the disclosure.

Referring to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In various embodiments of the disclosure, at least one (e.g., the connecting terminal 178) of the components may be omitted from the electronic device 101, or one or more other components may be added in the electronic device 101. In various embodiments of the disclosure, some of the components may be implemented as single integrated circuitry. For example, the sensor module 176, the camera module 180, or the antenna module 197 may be implemented as embedded in single component (e.g., the display module 160).

The processor 120 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing the recited /disclosed various functions, e.g., in a distributed manner. At least one processor may execute program instructions to achieve or perform various functions. The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally, or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to various embodiments of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5th generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4th generation (4G) network, and next-generation communication technology, e.g., new radio (NR) access technology. The NR access technology may support high-speed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to various embodiments of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink DL and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to various embodiments of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

The commands or data may be transmitted or received between the electronic device 101 and the external electronic device 104 via the server 108 connected to the second network 199. Each of the external electronic devices 102 or 104 may be the same or a different type of device as the electronic device 101. All or part of the operations executed in the electronic device 101 may be executed in one or more of the external electronic devices 102, 104, or 108. For example, when the electronic device 101 is to perform certain functions or services automatically or in response to a request from a user or other devices, instead of performing the functions or services by itself or additionally, the electronic device 101 may request one or more external electronic devices to perform at least some of the functions or services. One or more external electronic devices receiving the request may perform at least some of the requested functions or services, or an additional function or service related to the request, and transmit the result of the execution to the electronic device 101. The electronic device 101 may process the result as it is or additionally and provide the processed result as at least a portion of a response to the request. For example, the external electronic device 102 may render content data executed in an application and then transmit the rendered content data to the electronic device 101, and the electronic device 101 may output the received content data via the display module 160. In various embodiments, when the electronic device 101 detects movement of a user through the sensor module 176 (e.g., an inertial measurement unit (IMU) sensor), the processor 120 of the electronic device 101 may correct the rendering data received from the external electronic device 102 based on information on the movement of the user and output the corrected rendering data to the display module 160. In various embodiments, the processor 120 of the electronic device 101 may transmit the information on the movement of the user to the external electronic device 102 and request the external electronic device 102 to render screen data so that the screen data is updated according to the information on the movement of the user. In various embodiments, the external electronic device 102 may be provided in various forms, such as a smartphone or a casing device implemented to store and charge the electronic device 101.

The electronic device according to various embodiments of the disclosure may be various types of devices. The electronic device may include, for example, a portable communication device (e.g., a smart phone), a computer device, a portable multimedia device, a portable medical device, a camera, a wearable device, or a home appliance. However, the electronic device is not limited to the above-described devices.

Various embodiments of the disclosure and the terms used herein are not intended to limit the technical features described in the disclosure to specific embodiments. Regarding the description of the drawing, similar or related components will be denoted by similar reference numerals. A singular form of a noun corresponding to an item may include one or more of the items, unless the context clearly dictates otherwise. In the disclosure, each phrase such as "A or B", "at least one of A and B", "at least one of A or B", "A, B, or C", "at least one of A, B and C", and "at least one of A, B, or C" may include any one of items listed together in the corresponding one of those phrases, or all possible combinations thereof. The terms "first", "second", or the like, may be used only to distinguish one component from the other components, and do not limit the corresponding components in other respects (e.g., importance or a sequence). When one component (e.g., first component) is referred to as "coupled" or "connected" to another component (e.g., second component) with or without the term "functionally" or "communicatively", it means that the component may be connected to another component directly (e.g., in a wired manner), wirelessly, or through a third component.

The term "module" may include units implemented by hardware, software, or firmware, or any combination thereof and may be used interchangeably with terms such as, for example, logics, logic blocks, components, circuits, or the like. The module may be an integrally configured component or a minimum unit performing one or more functions or a portion thereof. For example, according to various embodiments of the disclosure, the module may be implemented in the form of an application-specific integrated circuit (ASIC).

Various embodiments of the disclosure may be implemented by software (e.g., the program 140) including one or more instructions stored in a storage medium (e.g., the internal memory 136 or the external memory 138) readable by a machine (e.g., the electronic device 101). For example, the processor (e.g., processor 120) of the machine (e.g., electronic device 101) may call and execute at least one of one or more instructions stored from the storage medium. This makes it possible for the machine to be operated to perform at least one function according to the invoked at least one instruction. The one or more instructions may include a code generated by a compiler or a code that may be executed by an interpreter. The storage medium readable by the machine may be provided in the form of a non-transitory storage medium. Here, the term 'non-transitory' only means that the storage medium is a tangible device and does not comprise a signal (e.g., an electromagnetic wave), and does not distinguish a case that data is semi-permanently stored in the storage medium or a case that data is temporarily stored in the storage medium from each other.

The methods according to various embodiments of the disclosure may be included and provided in a computer program product. The computer program product may be traded as a product between a seller and a purchaser. The computer program product may be distributed in the form of a storage medium (e.g., a compact disc read only memory (CD-ROM)) readable by the machine or may be distributed (e.g., downloaded or uploaded) online through an application store (e.g., PlayStore^{™}) or directly between two user devices (e.g., smartphones). In case of the online distribution, at least a portion of the computer program product may be at least temporarily stored in the storage medium readable by the machine, such as a memory of a server of a manufacturer, a server of an application store, or a relay server or be temporarily created.

Each component (e.g., module or program) of the above-described components may include one entity or a plurality of entities. One or more of the components or operations of the above-described components may be omitted, or one or more other components or operations may be added. Alternatively or additionally, a plurality of components (e.g., modules or programs) may be integrated into one component. In this case, the integrated component may perform one or more functions of each of the plurality of components identically or similarly to those performed by the corresponding component among the plurality of components prior to the integration. The operations performed by the modules, the program modules, or the other components may be executed in a sequential manner, a parallel manner, an iterative manner, or a heuristic manner, at least some of the operations may be performed in a different order or be omitted, or one more other operations may be added.

In the disclosure, "arranged in (on) XX" may be understood as disposed adjacent to XX, disposed in substantial contact with XX, or coupled to XX.

In this disclosure, "located in (on) XX" may be understood as positioned adjacent to XX, positioned in substantial contact with XX, or coupled to XX.

In the disclosure, when the term "substantially" is used to define a structural portion (a structure or a structural element), the expression including the term "substantially" is to be understood or interpreted as a technical feature produced within the technical tolerances of a method used to manufacture it. Also, the expression "include" means that a certain effect or result can be obtained within a certain tolerance, and that a person skilled in the art knows how to obtain that tolerance.

In the disclosure, a "comparative example" is provided only for comparison with embodiments of the disclosure and are not intended to have prior status with respect to the various embodiments of the disclosure.

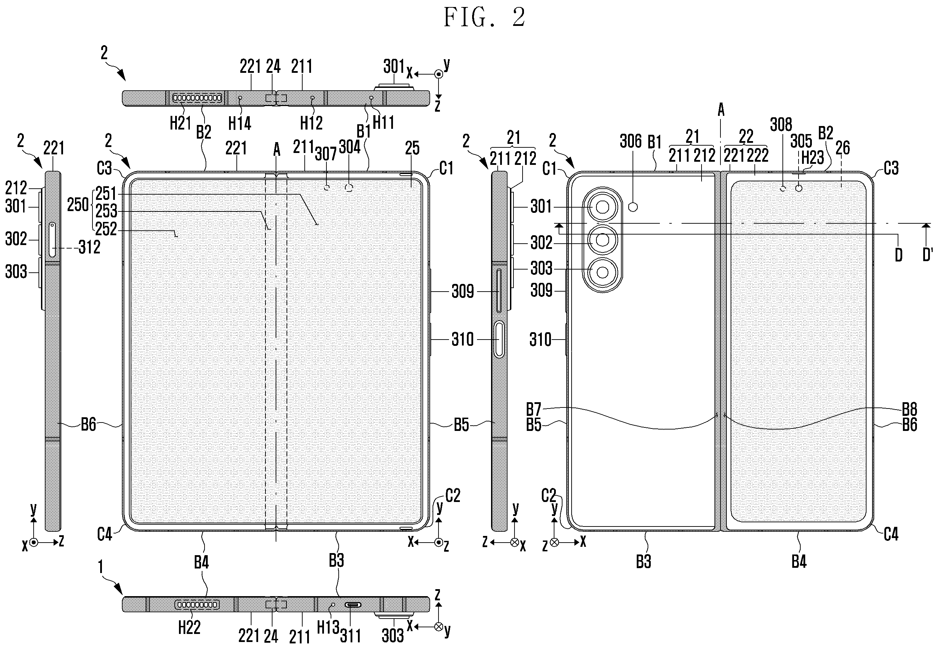

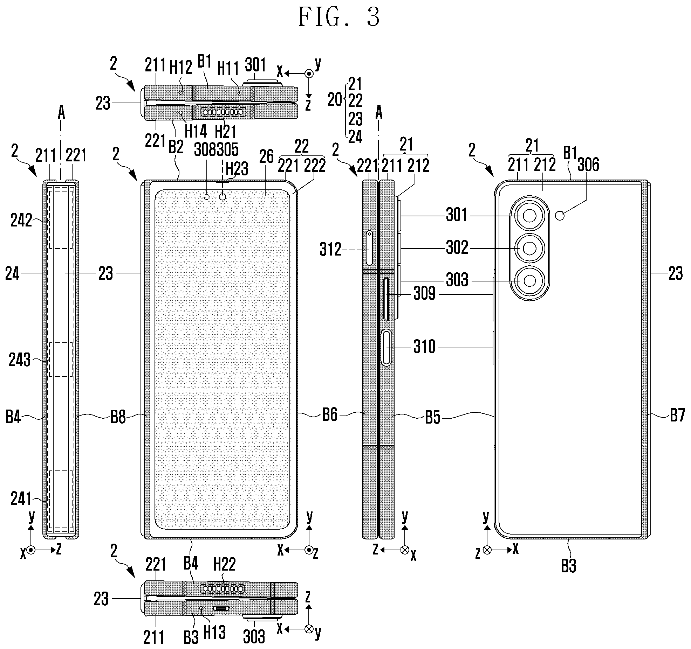

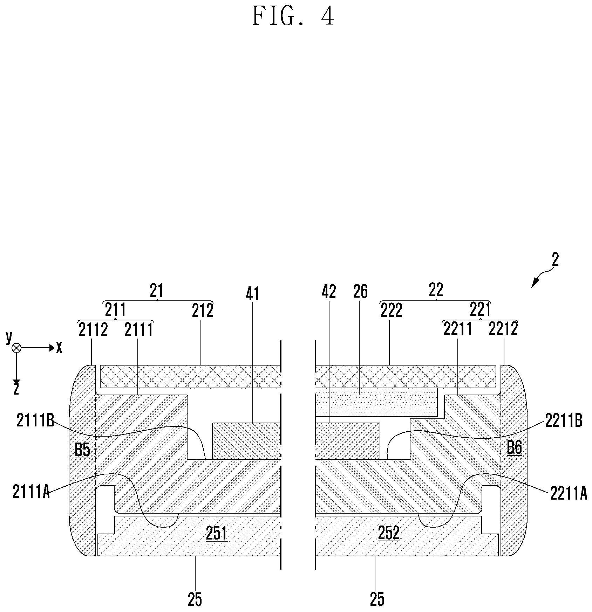

FIG. 2 is a diagram illustrating appearances of a foldable electronic device 2 in an unfolded state (also referred to as an unfolding state or a flat state), according to various embodiments of the disclosure. FIG. 3 is a diagram illustrating appearances of a foldable electronic device 2 in a folded state (also referred to as a folding state), according to various embodiments of the disclosure. FIG. 4 is a cross-sectional view of a foldable electronic device 2 in an unfolded state taken along line D-D' of FIG. 2, according to various embodiments of the disclosure.

It is to be understood that the disclosure contemplates and includes all combinations of the features and/or embodiments disclosed in relation to FIGS. 2, 3, and 4. All combinations of the features described below in relation to FIGS. 2, 3, and 4 may be considered to be included in the disclosure as specific examples.

Referring to FIGS. 2, 3, and 4, the foldable electronic device 2 may include a foldable housing 20 and a first display module 25. In various embodiments, the foldable electronic device 2 may be the electronic device 101 of FIG. 1.

According to various embodiments, the unfolded state and the folded state of the foldable electronic device 2 may be provided (or formed) by the foldable housing 20. The "unfolded state of the foldable electronic device 2" and the "unfolded state of the foldable housing 20" described in the disclosure may be understood as the same. The "folded state of the foldable electronic device 2" and the "folded state of the foldable housing 20" described in the disclosure may be understood as the same.

According to various embodiments, the foldable housing 20 may include a first housing 21 (also referred to as a first housing portion or a first housing structure), a second housing 22 (also referred to as a second housing portion or a second housing structure), a hinge cover 23, and/or a hinge portion 24. The first housing 21 and the second housing 22 may be rotatably connected via the hinge portion 24. The first housing 21 and the second housing 22 may be rotatable relative to each other with respect to the hinge portion 24. The hinge portion 24 (also referred to as a hinge structure, a hinge module, or a hinge assembly) may include, for example, one or more hinges (e.g., a first hinge 241, a second hinge 242, and/or a third hinge 243).

According to various embodiments, the first display module 25 (also referred to as a first display) may be disposed in the foldable housing 20. The first display module 25 may include, for example, a flexible display module (also referred to as a flexible display) or a foldable display module (also referred to as a foldable display) that may be deformed in response to a transition between the unfolded state and the folded state of the foldable electronic device 2.

According to various embodiments, the first display module 25 may include a display area 250. The display area 250 may include an active area or a screen area capable of displaying an image based on an electrical signal. The display area 250 may include a first display area 251 corresponding to the first housing 21, a second display area 252 corresponding to the second housing 22, and a third display area 253 corresponding to the hinge portion 24. The third display area 253 may extend the first display area 251 and the second display area 252.

According to various embodiments, the first display area 251 may be disposed in the first housing 21. The shape of the first display area 251 may be maintained by the support of the first housing 21. For example, the first display area 251 may be provided (or formed) to be substantially flat by being supported by the first housing 21. The second display area 252 may be disposed in the second housing 22. The shape of the second display area 252 may be maintained by the support of the second housing 22. For example, the second display area 252 may be provided (or formed) to be substantially flat by being supported by the second housing 22. The third display area 253 may be positioned corresponding to the hinge portion 24. When the foldable electronic device 2 switches between the unfolded state and the folded state, the third display area 253 may be deformed corresponding to a relative position between the first display area 251 and the second display area 252. In the unfolded state of the foldable electronic device 2, the third display area 253 may be arranged substantially flat. In the folded state of the foldable electronic device 2, the third display area 253 may be arranged in a bent form. The unfolded state of the foldable electronic device 2 may be understood as a state in which the third display area 253 is arranged flat. The folded state of the foldable electronic device 2 may be understood as a state in which the third display area 253 is arranged in a bent form. In the disclosure, when the term "substantially" is used to limit or define a structural portion, the expression including the term "substantially" is understood or interpreted as a technical feature produced within the technical tolerances of a method used to manufacture it. Also, the expression "include" means that a certain effect or result can be obtained within a certain tolerance, and that a person skilled in the art knows how to obtain that tolerance.

According to various embodiments, in the unfolded state of the foldable electronic device 2, the first display area 251 and the second display area 252 may form an angle of about 180 degrees, and the display area 250 may be provided (or arranged) in a substantially flat form. A flat form in the sense of the disclosure means that the display area 250 extends in a two-dimensional plane. A substantially flat form allows a deviation of five degrees with respect to a flat form. Due to the relative position between the first display area 251 arranged in the first housing 21 and the second display area 252 arranged in the second housing 22 in the unfolded state of the foldable electronic device 2, the third display area 253 may be arranged flat. In the unfolded state of the foldable electronic device 2, the third display area 253 may be pulled from both sides by the first display area 251 and the second display area 252, and the pulling force may be provided so as to reduce damage to the third display area 253 while allowing the third display area 253 to be arranged flat. In the unfolded state of the foldable electronic device 2, the third display area 253 may be provided (or formed) with an extended width that allows it to be arranged flat while reducing stress, by being pulled by the first display area 251 and the second display area 252.

According to various embodiments, in the unfolded state of the foldable electronic device 2, the hinge portion 24 may support the third display area 253 of the first display module 25 to be substantially flat. For example, in the unfolded state of the foldable electronic device 2, the hinge portion 24 may support the third display area 253 so that the third display area 253 is arranged flat without sagging or with reduced sagging, thereby reducing a crease phenomenon.

According to various embodiments, the display area 250 of the first display module 25 may substantially provide (or form) the front surface of the outward appearance of the foldable electronic device 2. The front surface of the foldable electronic device 2 may include a first front surface area provided (or formed) by the first display area 251, a second front surface area provided (or formed) by the second display area 252, and a third front surface area provided (or formed) by the third display area 253. The coordinate axes of the foldable electronic device 2 are illustrated based on, for example, the first housing 21, and a direction parallel to the positive direction of the z-coordinate axis may be defined or interpreted as a direction in which the substantially flat first front surface area faces. For example, the first front surface area provided (or formed) by the first display area 251 may be substantially parallel to the x-y plane. In the unfolded state of the foldable electronic device 2, the front surface of the foldable electronic device 2 may be provided (or formed) as a substantially flat surface.

According to various embodiments, the foldable electronic device 2 may be implemented in an infolding manner in which the display area 250 of the first display module 25 (or the front surface of the foldable electronic device 2 where the display area 250 is visible) may be folded inward. FIG. 3 illustrates a fully folded state of the foldable electronic device 2 in which the first housing 21 and the second housing 22 are positioned so that they no longer come close. In the fully folded state of the foldable electronic device 2, the first display area 251 and the second display area 252 (or the first front surface area and the second front surface area) may face each other. For example, in the fully folded state of the foldable electronic device 2, the angle between the first housing 21 and the second housing 22 (or the angle between the first display area 251 and the second display area 252, or the angle between the first front surface area and the second front surface area) may be from about 0 degrees to about 10 degrees. In the fully folded state of the foldable electronic device 2, the display area 250 of the first display module 25 may be substantially invisible. Although not illustrated separately, the foldable electronic device 2 may be disposed in an intermediate state between the unfolded state and the fully folded state. For example, in the intermediate state of the foldable electronic device 2 in which the angle between the first housing 21 and the second housing 22 is greater than a certain angle, the foldable electronic device 2 may be configured to provide a usage environment in which a user can utilize the display area 250. Hereinafter, the "folded state of the foldable electronic device 2" in the disclosure may be understood as the fully folded state.

According to various embodiments, when viewing the foldable electronic device 2 in the unfolded state, the display area 250 of the first display module 25 may be provided (or formed) in a symmetrical shape with respect to the center line A of the foldable electronic device 2. When viewing the foldable electronic device 2 in the unfolded state, the center line A of the foldable electronic device 2 may correspond to the middle of a width of the third display area 253 extending from a first boundary between the first display area 251 and the third display area 253 to a second boundary between the second display area 252 and the third display area 253. The positive direction and the negative direction of the x-coordinate axis may be, for example, substantially perpendicular to the center line A, and the positive direction and the negative direction of the y-coordinate axis may be substantially parallel to the center line A. In various embodiments, the center line A of the foldable electronic device 2 may be configured as a "folding axis" of the foldable housing 20 or the foldable electronic device 2. The folding axis may be substantially provided (or formed) by the hinge portion 24. The third display area 253 disposed in a bent shape in the folded state of the foldable electronic device 2 may be provided (or formed) in a substantially symmetrical shape with respect to the center line A of the foldable electronic device 2, but is not limited thereto.

According to various embodiments, the first housing 21 may include a first frame 211 (also referred to as a first frame structure or a first framework), and a first cover 212 (also referred to as a first rear cover, a first rear plate, a first back cover, or a first back plate) disposed on (or combined with) the first frame 211. The combination of the first frame 211 and the first cover 212 may provide (or form) a first rear surface area and a first side surface area of the outward appearance of the foldable electronic device 2. The first frame 211 may provide (or form) at least in part the first side surface area of the foldable electronic device 2. The first cover 212 may provide (or form) at least in part the first rear surface area of the foldable electronic device 2. The first rear surface area may face in the opposite direction to the first front surface area of the foldable electronic device 2 provided (or formed) by the first display area 251 of the first display module 25.

According to various embodiments, the first frame 211 may include a first side 2112 (also referred to as a first lateral member, a first lateral structure, or a first lateral bezel structure). The first side 2112 may surround at least in part a space between the first display area 251 and the first cover 212, and may provide (or form) at least in part the first side surface area of the outward appearance of the foldable electronic device 2.

According to various embodiments, the first frame 211 may include a first support plate 2111 (also referred to as a first support member, a first support structure, a first support portion, or a first bracket) extending from or connected to the first side 2112. The first support plate 2111 may be a structural element positioned inside the foldable electronic device 2 to correspond to the first housing 21.

According to various embodiments, the first frame 211 may be provided (or formed) as an integrated or single structure (e.g., a single continuous structure or a complete structure) including the first support plate 2111 and the first side 2112.

According to various embodiments, the first frame 211 may be provided as a combination of a conductive body (or metal body) (not shown separately) including one or more conductive portions and a non-conductive body (or non-metal body) (not shown separately) including one or more non-conductive portions.

According to various embodiments, the first support plate 2111 may be positioned at least in part between the first display area 251 and the first cover 212. The first display area 251 may be disposed on the first support plate 2111, and the first support plate 2111 may support the first display area 251.

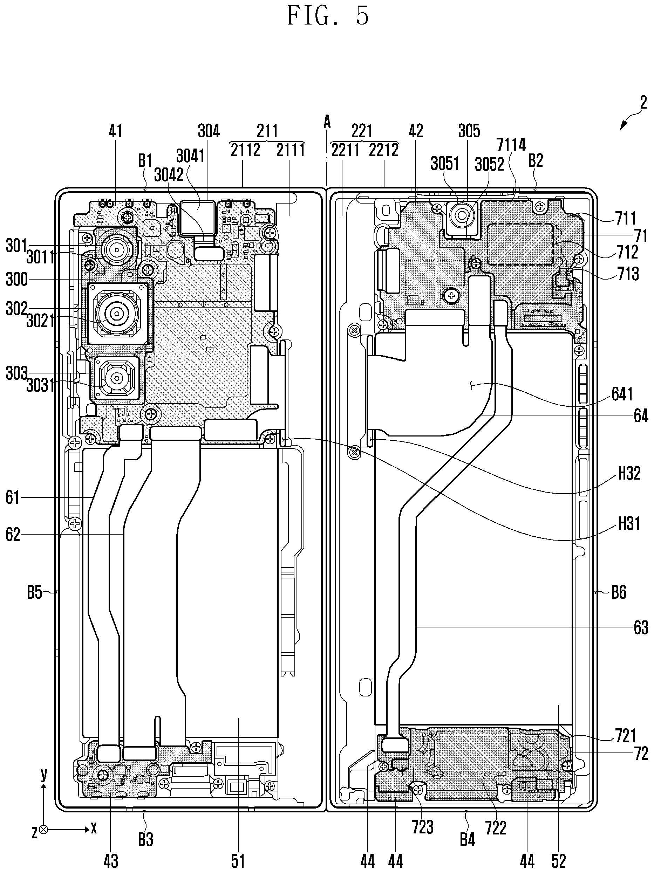

According to various embodiments, a plurality of electrical components, such as at least one PCB (e.g., the first PCB 41 and the third PCB 43 in FIG. 5) and a first battery (e.g., the first battery 51 in FIG. 5), may be at least in part disposed on or combined with the first support plate 2111 of the first frame 211 between the first frame 211 and the first cover 212.

According to various embodiments, electrical components (or electronic components), or various members related to the electrical components, may be disposed on or combined with the first frame 211 or the first support plate 2111, or may be supported by the first frame 211 or the first support plate 2111. The first support plate 2111 may include, for example, a first support surface 2111A and a third support surface 2111B. The first support surface 2111A may substantially face the first display area 251 of the first display module 25. The third support surface 2111B may be positioned opposite the first support surface 2111A. The third support surface 2111B may substantially face the first cover 212. Electrical components (or electronic components), or various members related to the electrical components, may be disposed on or combined with the first support surface 2111A and/or the third support surface 2111B, or may be supported by the first support surface 2111A and/or the third support surface 2111B.

According to various embodiments, the second housing 22 may include a second frame 221 (also referred to as a second frame structure or a second framework), and/or a second cover 222 (also referred to as a second rear cover, a second rear plate, a second back cover, or a second back plate) disposed on the second frame 221. The combination of the second frame 221 and the second cover 222 may provide (or form) a second rear area and a second side surface area of the outward appearance of the foldable electronic device 2. The second frame 221 may provide (or form) at least in part the second side area surface of the foldable electronic device 2. The second cover 222 may provide (or form) at least in part the second rear surface area of the foldable electronic device 2. The second rear surface area may face in the opposite direction to the second front surface area of the foldable electronic device 2 provided (or formed) by the second display area 252.

According to various embodiments, the second frame 221 may include a second side 2212 (also referred to as a second lateral member, a second lateral structure, or a second lateral bezel structure). The second side 2212 may surround at least in part a space between the second display area 252 and the second cover 222, and may provide (or form) at least in part the second side surface area of the outward appearance of the foldable electronic device 2.

According to various embodiments, the second frame 221 may include a second support plate 2211 (also referred to as a second support member, a second support structure, a second support portion, or a second bracket) extending from or connected to the second side 2212. The second support plate 2211 may be a structural element positioned inside the foldable electronic device 2 to correspond to the second housing 22.

According to various embodiments, the second frame 221 may be provided as an integrated or single structure (e.g., a single continuous structure or a complete structure) including the second support plate 2211 and the second side 2212.

According to various embodiments, the second frame 221 may be provided as a combination of a conductive body (or metal body) (not shown separately) including one or more conductive portions and a non-conductive body (or non-metal body) (not shown separately) including one or more non-conductive portions.

According to various embodiments, the second support plate 2211 may be positioned at least in part between the second display area 252 and the second cover 222. The second display area 252 may be disposed on the second support plate 2211, and the second support plate 2211 may support the second display area 252.

According to various embodiments, a plurality of electrical components, such as at least one PCB (e.g., the second PCB 42 and the fourth PCB 44 in FIG. 5) and a second battery (e.g., the second battery 52 in FIG. 5), may be at least in part disposed on or combined with the second support plate 2211 of the second frame 221 between the second frame 221 and the second cover 222.

According to various embodiments, electrical components (or electronic components), or various members related to the electrical components, may be disposed on or combined with the second frame 221 or the second support plate 2211, or may be supported by the second frame 221 or the second support plate 2211. The second support plate 2211 may include, for example, a second support surface 2211A and a fourth support surface 2211B. The second support surface 2211A may substantially face the second display area 252 of the first display module 25. The fourth support surface 2211B may be positioned opposite the second support surface 2211A. The fourth support surface 2211B may substantially face the second cover 222. Electrical components (or electronic components), or various members related to the electrical components, may be disposed on or combined with the second support surface 2211A and/or the fourth support surface 2211B, or may be supported by the second support surface 2211A and/or the fourth support surface 2211B.

According to various embodiments, the first side 2112 of the first frame 211 may include a first lateral portion B1, a third lateral portion B3, a fifth lateral portion B5, and/or a seventh lateral portion B7. The first lateral portion B1 may extend in a direction perpendicular to the center line A of the foldable electronic device 2 (e.g., a direction parallel to the x-coordinate axis). The third lateral portion B3 may be spaced apart from the first lateral portion B1 in a direction parallel to the center line A of the foldable electronic device 2 (e.g., a direction parallel to the y-coordinate axis) and may be substantially parallel to the first lateral portion B1. The fifth lateral portion B5 may extend or connect one end of the first lateral portion B1 and one end of the third lateral portion B3. The seventh lateral portion B7 may extend or connect the other end of the first lateral portion B1 and the other end of the third lateral portion B3. The fifth lateral portion B5 and the seventh lateral portion B7 may extend in a direction parallel to the center line A of the foldable electronic device 2 and may be substantially parallel to each other. The seventh lateral portion B7 may be positioned closer to the center line A of the foldable electronic device 2 than the fifth lateral portion B5. A first corner C1 where the first lateral portion B1 and the fifth lateral portion B5 extend or are connected, and/or a second corner C2 where the third lateral portion B3 and the fifth lateral portion B5 extend or are connected, may be provided (or formed) in a smooth curved shape.

According to various embodiments, when viewed from above the first cover 212 (which may be understood as "when viewed in a direction perpendicular to the first cover 212") (e.g., when viewed in the positive direction of the z-coordinate axis), the first lateral portion B1, the third lateral portion B3, the fifth lateral portion B5, and the seventh lateral portion B7 may surround the first cover 212.

According to various embodiments, the second side 2212 of the second frame 221 may include a second lateral portion B2, a fourth lateral portion B4, a sixth lateral portion B6, and/or an eighth lateral portion B8. The second lateral portion B2 may extend in a direction perpendicular to the center line A of the foldable electronic device 2. The fourth lateral portion B4 may be spaced apart from the second lateral portion B2 in a direction parallel to the center line A of the foldable electronic device 2 and may be substantially parallel to the second lateral portion B2. The sixth lateral portion B6 may extend or connect one end of the second lateral portion B2 and one end of the fourth lateral portion B4. The eighth lateral portion B8 may extend or connect the other end of the second lateral portion B2 and the other end of the fourth lateral portion B4. The sixth lateral portion B6 and the eighth lateral portion B8 may extend in a direction parallel to the center line A of the foldable electronic device 2 and may be substantially parallel to each other. The eighth lateral portion B8 may be positioned closer to the center line A of the foldable electronic device 2 than the sixth lateral portion B6. A third corner C3 where the second lateral portion B2 and the sixth lateral portion B6 extend or are connected, and/or a fourth corner C4 where the fourth lateral portion B4 and the sixth lateral portion B6 extend or are connected, may be provided (or formed) in a smooth curved shape.

According to various embodiments, when viewed from above the second cover 222 (which may be understood as "when viewed in a direction perpendicular to the second cover 222") (e.g., when viewed in the positive direction of the z-coordinate axis in the unfolded state of the foldable electronic device 2), the second lateral portion B2, the fourth lateral portion B4, the sixth lateral portion B6, and the eighth lateral portion B8 may surround the second cover 222.

According to various embodiments, in the folded state of the foldable electronic device 2, the first side 2112 of the first frame 211 and the second side 2212 of the second frame 221 may be aligned and overlapped. In the folded state of the foldable electronic device 2, the first lateral portion B1 and the second lateral portion B2 may be aligned and overlapped. In the folded state of the foldable electronic device 2, the third lateral portion B3 and the fourth lateral portion B4 may be aligned and overlapped. In the folded state of the foldable electronic device 2, the fifth lateral portion B5 and the sixth lateral portion B6 may be aligned and overlapped.

According to various embodiments, the first lateral portion B1, the third lateral portion B3, and the fifth lateral portion B5 may be one bezel (or a first screen bezel) surrounding one area of the first display module 25 with respect to the center line A of the foldable electronic device 2. The second lateral portion B2, the fourth lateral portion B4, and the sixth lateral portion B6 may be the other bezel (or a second screen bezel) surrounding the other area of the first display module 25 with respect to the center line A of the foldable electronic device 2. The seventh lateral portion B7 and the eighth lateral portion B8 may be positioned opposite the third display area 253. When viewed from above the front of the foldable electronic device 2 in the unfolded state, the seventh lateral portion B7 and the eighth lateral portion B8 may not be visible.

According to various embodiments, the hinge cover 23 (also referred to as a hinge housing) may be connected to one or more hinges (e.g., a first hinge 241, a second hinge 242, and a third hinge 243) included in the hinge portion 24.

According to various embodiments, when the foldable electronic device 2 is switched from the unfolded state to the folded state, a gap between the first frame 211 and the second frame 221 may open on the opposite side of the third display area 253 due to a change in the relative position between the first and second frames 211 and 221 connected through the hinge portion 24 and a change in the state of the hinge portion 24 combined with the hinge cover 23. The hinge cover 23 may be exposed to the outside through the open gap. For example, in the folded state of the foldable electronic device 2, the hinge cover 23 may be exposed to the outside through the open gap between the seventh lateral portion B7 of the first frame 211 and the eighth lateral portion B8 of the second frame 221. The width of the gap between the seventh lateral portion B7 of the first frame 211 and the eighth lateral portion B8 of the second frame 221 may vary depending on the angle between the first frame 211 and the second frame 221. The hinge cover 23 may be more exposed to the outside in the folded state of the foldable electronic device 2 than in the intermediate state of the foldable electronic device 2. In the folded state of the foldable electronic device 2, the hinge cover 23 may become a part of the outward appearance that covers the inside of the foldable electronic device 2. In the folded state of the foldable electronic device 2, the side surface of the foldable electronic device 2 may include a first side surface area provided by the first side 2112 of the first frame 211, a second side surface area provided by the second side 2212 of the second frame 221, and a third side surface area provided by the hinge cover 23.

According to various embodiments, when the foldable electronic device 2 is switched from the folded state to the unfolded state, the gap between the first frame 211 and the second frame 221 may be closed on the opposite side of the third display area 253 due to a change in the relative position between the first and second frames 211 and 221 connected through the hinge portion 24 and a change in the state of the hinge portion 24 combined with the hinge cover 23. For example, in the unfolded state of the foldable electronic device 2, the gap between the seventh lateral portion B7 of the first frame 211 and the eighth lateral portion B8 of the second frame 221 may be closed, and the hinge cover 23 may not be exposed to the outside.

According to various embodiments, the foldable electronic device 2 may include a second display module 26 (also referred to as a second display). The second display module 26 may be positioned between the second cover 222 and the second support plate 2211 of the second frame 221. The second display module 26 may be disposed on or combined with the second cover 222 and/or the second support plate 2211. A display area of the second display module 26 may be visible through the second cover 222. The foldable electronic device 2 may be configured to display an image through the second display module 26 instead of the first display module 25 in the folded state.

According to various embodiments, the foldable electronic device 2 may include a first camera module 301, a second camera module 302, a third camera module 303, a fourth camera module 304, and/or a fifth camera module 305. The first camera module 301, the second camera module 302, the third camera module 303, the fourth camera module 304, or the fifth camera module 305 may include a camera that includes one or more lenses, image sensor(s), and/or an image signal processor (ISP).

According to various embodiments, the first camera module 301, the second camera module 302, and the third camera module 303 may be accommodated in the first housing 21 to correspond to the first cover 212 (or the first rear area of the foldable electronic device 2). For example, the first cover 212 may include a first camera hole (or a first light-transmitting area) corresponding to the first camera module 301, a second camera hole (or a second light-transmitting area) corresponding to the second camera module 302, and/or a third camera hole (or a third light-transmitting area) corresponding to the third camera module 303. The positions or number of such camera modules accommodated in the first housing 21 to correspond to the first cover 212 is not limited to the illustrated example.

According to various embodiments, the first camera module 301, the second camera module 302, or the third camera module 303 may include, but is not limited to, a wide- angle camera, a telephoto camera, a color camera, a black and white camera, or an infrared (IR) camera (e.g., a time of flight (TOF) camera, a structured light camera).

According to various embodiments, the first camera module 301, the second camera module 302, and the third camera module 303 may have different properties (e.g., angles of view) or functions.

According to various embodiments, the first camera module 301, the second camera module 302, or the third camera module 303 may provide different angles of view (or lenses with different angles of view). The foldable electronic device 2 may be configured to selectively use the angle of view of the first camera module 301, the second camera module 302, or the third camera module 303 based on a user's selection regarding the angle of view.

According to various embodiments, the fourth camera module 304 may be accommodated in the first housing 21 to correspond to the first front surface area of the foldable electronic device 2.

According to various embodiments, when viewed from above the first front surface area of the foldable electronic device 2, the fourth camera module 304 may overlap with the first display area 251 of the first display module 25. The fourth camera module 304 may be positioned on the rear surface of the first display area 251 or under the first display area 251. When viewed from the outside of the foldable electronic device 2, the fourth camera module 304, or the position of the fourth camera module 304, may not be substantially visually distinguishable (or exposed). The fourth camera module 304 may include, for example, a hidden display rear camera (e.g., an under display camera (UDC)). External light may pass through the first display module 25 and reach the fourth camera module 304.

According to various embodiments, although not shown separately, the fourth camera module 304 may be accommodated in the second housing 22 to correspond to the second front surface area of the foldable electronic device 2.

According to various embodiments, although not shown separately, an additional camera module (not shown separately) may be accommodated in the second housing 22 to correspond to the second front surface area of the foldable electronic device 2.

According to various embodiments, the fifth camera module 305 may be accommodated in the second housing 22 to correspond to the second cover 222 (or the second rear surface area of the foldable electronic device 2).

According to various embodiments, the fifth camera module 305 may be positioned in alignment with or at least partially inserted into an opening provided in the second display module 26. External light may pass through the second cover 222 and the opening provided in the second display module 26 and then reach the fifth camera module 305. The opening of the second display module 26 aligned or overlapped with the fifth camera module 305 may be a through hole. In various embodiments, the opening of the second display module 26 aligned or overlapped with the fifth camera module 305 may be provided as a notch (not shown separately).

According to various embodiments, the fifth camera module 305 may overlap with the second display module 26 when viewed from above the second rear surface area of the foldable electronic device 2. The fifth camera module 305 may be positioned on the rear surface of the second display module 26 or under the second display module 26. When viewed from the outside of the foldable electronic device 2, the fifth camera module 305, or the position of the fifth camera module 305, may not be substantially visually distinguishable (or exposed). The fifth camera module 305 may include, for example, a hidden display rear camera (e.g., UDC). External light may pass through the second cover 222 and the second display module 26 and reach the fifth camera module 305.

According to various embodiments, the first camera module 301, the second camera module 302, the third camera module 303, the fourth camera module 304, or the fifth camera module 305 may be configured to operate as at least a part of the sensor module. For example, the IR camera module may operate as at least a part of the sensor module.

According to various embodiments, the foldable electronic device 2 may include a light-emitting module 306. The light-emitting module 306 may be accommodated in the first housing 21 to correspond to the first cover 212 (or the first rear surface area of the foldable electronic device 2). The first cover 212 may include a flash hole (or a fourth light-transmitting area) corresponding to the light-emitting module 306. The light-emitting module 306 may include, for example, a light-emitting diode (LED) or a xenon lamp, but is not limited thereto. The light-emitting module 306 may include a light source for the first camera module 301, the second camera module 302, and/or the third camera module 303.

According to various embodiments, the foldable electronic device 2 may include a first sensor module 307. The first sensor module 307 may be accommodated in the foldable housing 20 to correspond to the front surface of the foldable electronic device 2.

According to various embodiments, the first sensor module 307 may include an optical sensor module. The optical sensor module may include, for example, a proximity sensor module or an illuminance sensor module.

According to various embodiments, the first sensor module 307 may overlap with the first display area 251 of the first display module 25 when viewed from above the first front surface area of the foldable electronic device 2. The first sensor module 307 may be positioned on the rear surface of the first display area 251 or under the first display area 251. When viewed from the outside of the foldable electronic device 2, the first sensor module 307, or the position of the first sensor module 307, may not be substantially visually distinguishable (or exposed). External light may pass through the first display module 25 and reach the first sensor module 307.

According to various embodiments, the foldable electronic device 2 may include a second sensor module 308. The second sensor module 308 may be accommodated in the foldable housing 20 to correspond to the rear surface of the foldable electronic device 2.

According to various embodiments, the second sensor module 308 may include an optical sensor module. The optical sensor module may include, for example, a proximity sensor module, an illuminance sensor module, or a radar sensor module.

According to various embodiments, the second sensor module 308 may overlap with the display area of the second display module 25 when viewed from above the second rear surface area of the foldable electronic device 2. The second sensor module 308 may be positioned on the rear surface of the display area of the second display module 25 or under the display area of the second display module 25. When viewed from the outside of the foldable electronic device 2, the second sensor module 308, or the position of the second sensor module 308, may not be substantially visually distinguishable (or exposed). External light may pass through the second cover 222 and the second display module 26 and reach the second sensor module 308.

According to various embodiments, the foldable electronic device 2 may further include various other sensor modules (e.g., a biometric sensor module) (not shown separately).

According to various embodiments, the foldable electronic device 2 may include a first audio input module (not shown separately), a second audio input module (not shown separately), a third audio input module (not shown separately), and/or a fourth audio input module (not shown separately). The first audio input module may include a first microphone (also referred to as a first microphone) (not shown separately). For example, the first microphone may be accommodated in the first housing 21 to correspond to a first microphone hole H11 included in the first lateral portion B1 of the first side 2112. The second audio input module may include a second microphone (also referred to as a second microphone) (not shown separately). For example, the second microphone may be accommodated in the first housing 21 to correspond to a second microphone hole H12 included in the first lateral portion B1 of the first side 2112. The third sound input module may include a third microphone (also referred to as a third microphone) (not shown separately). For example, the third microphone may be accommodated in the first housing 21 to correspond to a third microphone hole H13 included in the third lateral portion B3 of the first side 2112. The fourth sound input module may include a fourth microphone (also referred to as a fourth microphone) (not shown separately). For example, the fourth microphone may be accommodated in the second housing 22 to correspond to a fourth microphone hole H14 included in the second lateral portion B2 of the second side 2212. The locations or number of such microphones and the corresponding microphone holes is not limited to the illustrated example.

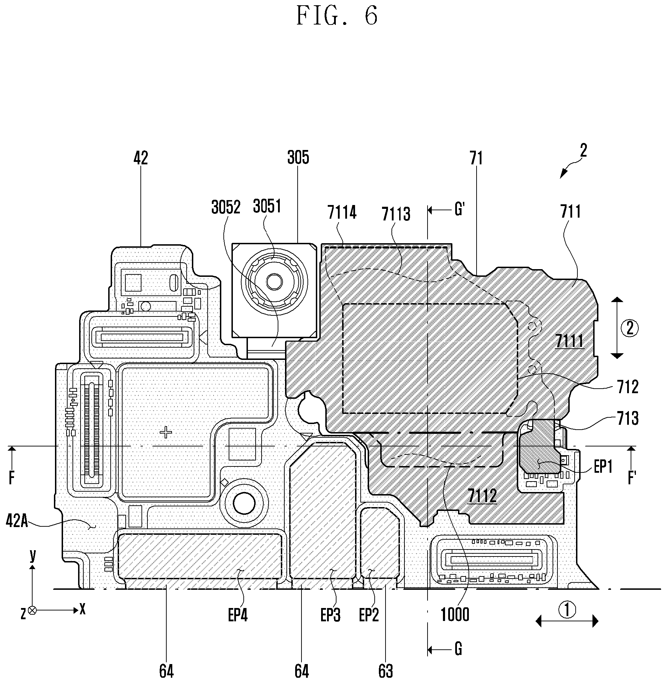

According to various embodiments, the foldable electronic device 2 may include a first audio output module (e.g., a first speaker module 71 in FIG. 5), a second audio output module (e.g., a second speaker module 72 in FIG. 6), and/or a third audio output module (not shown separately). The first audio output module may include a first speaker (e.g., a first speaker 712 in FIG. 5). For example, the first speaker may be accommodated in the second housing 22 to correspond to a first speaker hole H21 included in the second lateral portion B2 of the second side 2212. The second audio output module may include a second speaker (e.g., a second speaker 722 in FIG. 5). For example, the second speaker may be accommodated in the second housing 22 to correspond to a second speaker hole H22 included in the fourth lateral portion B4 of the second side 2212. The first speaker or the second speaker may be a speaker for multimedia playback or recording playback. The positions or number of such speakers for multimedia playback or recording playback and the corresponding speaker holes is not limited to the illustrated example. The third audio output module may include a third speaker (not shown separately). For example, the third speaker may be accommodated in the second housing 22 to correspond to a third speaker hole H23 provided between the second cover 222 and the second lateral portion B2 of the second side 2212. The third speaker may include a call receiver. The location or number of the call receiver and the corresponding speaker hole (also referred to as a receiver hole) is not limited to the illustrated example.

According to various embodiments, the foldable electronic device 2 may include a key input module. The key input module may include, for example, a first key 309 (also referred to as a first side key) and/or a second key 310 (also referred to as a second side key). The key input module may include a key signal generator (not shown separately). The first key 309 may be positioned in a first key hole included in the fifth lateral portion B5 of the first side 2112, and the second key 310 may be positioned in a second key hole included in the fifth lateral portion B5 of the first side 2112. The key signal generator may be configured to generate a first key signal in response to a press or touch of the first key 309 and generate a second key signal in response to a press or touch of the second key 310. The locations or number of such key input modules is not limited to the illustrated example.

According to various embodiments, the foldable electronic device 2 may include a first connection terminal 311 (also referred to as a first connector or a first interface terminal). For example, the first connection terminal 311 may be accommodated in the first housing 21 to correspond to a first connection terminal hole (e.g., a first connector hole) included in the third lateral portion B3 of the first side 2112. The foldable electronic device 2 may transmit and/or receive power and/or data with an external electronic device electrically connected to the first connection terminal 311. The first connection terminal 311 may include, for example, a universal serial bus (USB) connector or a high-definition multimedia interface (HDMI) connector. The positions of the first connection terminal 311 and the corresponding first connection terminal hole are not limited to the illustrated example.

According to various embodiments, the foldable electronic device 2 may include a second connection terminal 312 (also referred to as a second connector or a second interface terminal). For example, the second connection terminal 312 may be accommodated in the second housing 22 to correspond to a second connection terminal hole (e.g., a second connector hole) included in the sixth lateral portion B6 of the second side 2212. An external storage medium such as a secure digital memory (SD) card, a subscriber identity module (SIM) card, or a universal SIM (USIM) card may be connected to the second connection terminal 312. The positions of the second connection terminal 312 and the corresponding second connection terminal hole are not limited to the illustrated example.

The foldable electronic device 2 may further include various components depending on its provision form. Such components are not all enumerated because they are modified in various ways depending on the convergence trend of the foldable electronic device 2, and components equivalent to the above-mentioned components may be additionally included in the foldable electronic device 2. In various embodiments, depending on their provision forms, certain components may be excluded from the above-mentioned components or replaced with other components.

FIG. 5 is a diagram illustrating a portion of a foldable electronic device 2 in an unfolded state, according to various embodiments of the disclosure.

It is to be understood that the disclosure contemplates and includes all combinations of the features and/or embodiments disclosed in connection with FIG. 5. All combinations of the features described below in connection with FIG. 5 may be considered to be included in the disclosure as specific examples.

Referring to FIG. 5, the foldable electronic device 2 may include a first printed circuit board (PCB) 41, a third PCB 43, and a first battery 51 arranged on or combined with the first support plate 2111 of the first frame 211. The first PCB 41, the third PCB 43, and the first battery 51 may be located between the first support plate 2111 and the first cover 212 (see FIG. 2). When viewed from above the first cover 212 (see FIG. 2), the first PCB 41 may be located closer to the first lateral portion B1 of the first frame 211 than the third PCB 43. When viewed from above the first cover 212 (see FIG. 2), the third PCB 43 may be located closer to the third lateral portion B3 of the first frame 211 than the first PCB 41. When viewed from above the first cover 212 (see FIG. 2), the first battery 51 may be located between the first PCB 41 and the third PCB 43. In the disclosure, "disposed on XX" may be understood as located adjacent to or substantially in contact with XX, or combined with XX.

According to various embodiments, the foldable electronic device 2 may include a first flexible printed circuit board (FPCB) 61 and a second FPCB 62 electrically connecting the first PCB 41 and the third PCB 43. The first FPCB 61 and the second FPCB 62 may be disposed across a space between the first battery 51 and the first cover 212 (see FIG. 2). The first FPCB 61 and the second FPCB 62 may be disposed across the first battery 51 and may be disposed on or combined with the first battery 51. When viewed from above the first cover 212 (see FIG. 2), the first FPCB 61 and the second FPCB 62 may overlap with the first battery 51. The number or locations of FPCBs electrically connecting the first PCB 41 and the third PCB 43 are not limited to the illustrated example.

According to various embodiments, the foldable electronic device 2 may include a camera bracket 300 disposed on or combined with the first support plate 2111 of the first frame 211. The camera bracket 300 may be located between the first support plate 2111 and the first cover 212 (see FIG. 2). When viewed from above the first cover 212 (see FIG. 2), the camera bracket 300 may be located closer to the first lateral portion B1 of the first frame 211 than the first battery 51. The first camera module 301 may include a first camera 3011 and a first camera FPCB (not shown separately) extended from the first camera 3011. The first camera 3011 may be disposed on and combined with the camera bracket 300. When viewed from above the first cover 212 (see FIG. 2), the first camera 3011 may not overlap with the first PCB 41. The first camera 3011 may be electrically connected to the first PCB 41 via the first camera FPCB. The second camera module 302 may include a second camera 3021 and a second camera FPCB (not shown separately) extended from the second camera 3021. The second camera 3021 may be disposed on and combined with the camera bracket 300. When viewed from above the first cover 212 (see FIG. 2), the second camera 3021 may not overlap with the first PCB 41. The second camera 3021 may be electrically connected to the first PCB 41 via the second camera FPCB. The third camera module 303 may include a third camera 3031 and a third camera FPCB (not shown separately) extended from the third camera 3031. The third camera 3031 may be disposed on and combined with the camera bracket 300. When viewed from above the first cover 212 (see FIG. 2), the third camera 3031 may not overlap with the first PCB 41. The third camera 3031 may be electrically connected to the first PCB 41 via the third camera FPCB.

According to various embodiments, the foldable electronic device 2 may include a fourth camera module 304. The fourth camera module 304 may include a fourth camera 3041 and a fourth camera FPCB 3042 extended from the fourth camera 3041. The fourth camera 3041 may be disposed on or combined with the first support plate 2111 between the first support plate 2111 and the first cover 212 (see FIG. 2). When viewed from above the first cover 212 (see FIG. 2), the fourth camera 3041 may not overlap with the first PCB 41. The fourth camera 3041 may be electrically connected to the first PCB 41 via the fourth camera FPCB 3042.

According to various embodiments, the foldable electronic device 2 may include a second PCB 42, a fourth PCB 44, and a second battery 52 disposed on or combined with the second support plate 2211 of the second frame 221. The second PCB 42, the fourth PCB 44, and the second battery 52 may be located between the second support plate 2211 and the second cover 222 (see FIG. 2). At least a portion of the second PCB 42, at least a portion of the fourth PCB 44, and/or at least a portion of the second battery 52 may be located between the second display module 26 (or a display area of the second display module 26) (see FIG. 2) and the second support plate 2211. When viewed from above the second cover 222 (see FIG. 2), the second PCB 42 may be located closer to the second lateral portion B2 of the second frame 221 than the fourth PCB 44. When viewed from above the second cover 222 (see FIG. 2), the fourth PCB 44 may be located closer to the fourth lateral portion B4 of the second frame 221 than the second PCB 42. When viewed from above the second cover 222 (see FIG. 2), the second battery 52 may be located between the second PCB 42 and the fourth PCB 44.

According to various embodiments, the foldable electronic device 2 may include a third FPCB 63 electrically connecting the second PCB 42 and the fourth PCB 44. The third FPCB 63 may be disposed across a space between the second battery 52 and the second cover 222 (see FIG. 2). The third FPCB 63 may be disposed across the second battery 52 and may be disposed on or combined with the second battery 52. When viewed from above the second cover 222 (see FIG. 2), the third FPCB 63 may overlap with the second battery 52. The number or locations of the FPCBs electrically connecting the second PCB 42 and the fourth PCB 44 are not limited to the illustrated example.

According to various embodiments, the foldable electronic device 2 may include a fourth FPCB 64 electrically connecting the first PCB 41 and the second PCB 42. The fourth FPCB 64 may path through a first hole H31 formed in the first support plate 2111 of the first frame 211 and a second hole H32 formed in the second support plate 2211 of the second frame 221. The fourth FPCB 64 may be disposed across the hinge portion 24 (see FIG. 2). In various embodiments, when viewed from above the second cover 222 (see FIG. 2), the fourth FPCB 64 may include a portion (hereinafter, referred to as a battery overlap portion 641) overlapping with the second battery 52, and the battery overlap portion 641 of the fourth FPCB 64 may be disposed on or combined with the second battery 52.

According to various embodiments, the foldable electronic device 2 may include a fifth camera module 305. The fifth camera module 305 may include a fifth camera 3051 and a fifth camera FPCB 3052 extended from the fifth camera 3051. The fifth camera 3051 may be disposed on or combined with the second support plate 2211 between the second support plate 2211 and the second cover 222 (see FIG. 2). When viewed from above the second cover 222 (see FIG. 2), the fifth camera 3051 may not overlap with the second PCB 42. The fifth camera 3051 may be electrically connected to the second PCB 42 via the fifth camera FPCB 3052.

According to various embodiments, the foldable electronic device 2 may include a first speaker module 71 (also referred to as a first speaker assembly). The first speaker module 71 (also referred to as a first component 71) may be accommodated in the second housing 22. When viewed from above the second cover 222 (see FIG. 2), the first speaker module 71 may be located between the second battery 52 and the second lateral portion B2 of the second frame 221. The first speaker module 71 may include a first speaker housing 711, a first speaker 712, and a first speaker FPCB 713.

According to various embodiments, the first speaker housing 711 of the first speaker module 71 may be located between the second support plate 2211 of the second frame 221 and the second cover 222. The first speaker housing 711 may be located between the second support plate 2211 and the second display module 26 (or the display area of the second display module 26) (see FIGS. 2 and 4).

According to various embodiments, the first speaker housing 711 of the first speaker module 71 may include a first sound output port 7114. When the first speaker 712 outputs audio signals received through the first speaker FPCB 713, sound generated by vibration of a diaphragm (not shown separately) of the first speaker 712 may be propagated in the air within the internal space of the first speaker housing 711 and output outside the first speaker housing 711 through the first sound output port 7114 of the first speaker housing 711. The first sound output port 7114 of the first speaker housing 711 may be disposed to correspond to the first speaker hole H21 (see FIG. 2) of the second frame 221, and the sound generated by the first speaker 712 may be output to the outside of the foldable electronic device 2 through the first sound output port 7114 of the first speaker housing 711 and the first speaker hole H21 (see FIG. 2) of the second frame 221.

According to various embodiments, the first speaker module 71 may include a first sound-transmissive member (not shown separately). The sound-transmissive member may be disposed on or combined with the first speaker housing 711 so as to be disposed in the first sound output port 7114 of the first speaker housing 711. Sound generated by the first speaker 712 may be output to the outside of the foldable electronic device 2 through the first sound-transmissive member. The first sound-transmissive member may include, for example, but is not limited to, a porous member or a mesh member. The first sound-transmissive member may reduce or prevent external foreign substances, such as dust or moisture, from flowing into the inside of the first speaker module 71 through the first sound output port 7114.

According to various embodiments, the first speaker module 71 may include a first elastic member (not shown separately). The first elastic member may be disposed on or combined with the first speaker housing 711. The first elastic member may be combined with the first sound-transmissive member and may support the first sound-transmissive member. For example, the first elastic member may be provided (or formed) in an annular shape (or a loop shape) including an opening corresponding to the first sound output port 7114 of the first speaker housing 711. The first elastic member may be resiliently disposed between the first speaker housing 711 and the second frame 221. The first elastic member may reduce or prevent sound generated by the first speaker 712 from leaking through the first speaker housing 711 and the second frame 221. Advantageously, the first elastic member may reduce or prevent external foreign substances, such as dust or moisture, from flowing into the inside of the first speaker module 71 through a space between the first speaker housing 711 and the second frame 221. The first elastic member may include, for example, but is not limited to, a sponge or rubber.

According to various embodiments, the first speaker 712 may be disposed in the first speaker housing 711. The first speaker 712 may be configured to convert an audio signal into a sound. The first speaker 712 may include, for example, a magnetic circuit, a coil structure, and a diaphragm, although not separately illustrated. The magnetic circuit may form a fixed magnetic field (also referred to as a permanent magnetic field). The coil structure may include a coil support member (e.g., a coil former) and a coil wound around the coil support member. When an audio signal in the form of a current (e.g., an alternating current) flows along the coil structure, a magnetic force may be generated to be induced toward a central axis around which the coil is wound. Due to the interaction between the induced magnetic force and the fixed magnetic field, the coil structure may move in the direction of the central axis, and the diaphragm connected to the coil structure may vibrate the air due to the movement of the coil structure.

According to various embodiments, the first speaker FPCB 713 may electrically connect the first speaker 712 and the second PCB 42. The first speaker FPCB 713 may pass through a hole (not shown separately) formed in the first speaker housing 711, and a portion of the first speaker FPCB 713 may be located outside the first speaker housing 711 for electrical connection with the second PCB 42. The first speaker FPCB 713 may be replaced with any other electrical connection member such as a cable.

According to various embodiments, the foldable electronic device 2 may include a **second** speaker module 72 (also referred to as a second speaker assembly). The second speaker module 72 may be accommodated in the second housing 22. The second speaker module 72 may be located between the second battery 52 and the fourth lateral portion B4 of the second frame 221 when viewed from above the second cover 222 (see FIG. 2). The second speaker module 72 may be provided (or formed) in a form of including at least some of the components of the first speaker module 71. The second speaker module 72 may include, for example, a second speaker housing 721 (e.g., the first speaker housing 711), a second speaker 722 (e.g., the first speaker 712), and a second speaker FPCB 723 (e.g., the first speaker FPCB 713). The second speaker module 72 may include, for example, a second sound-transmissive member (e.g., the first sound-transmissive member) and a second elastic member (e.g., the first elastic member).

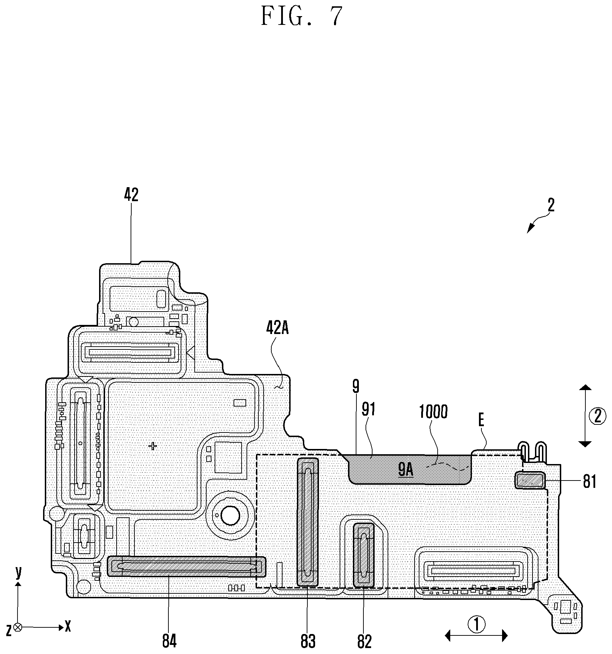

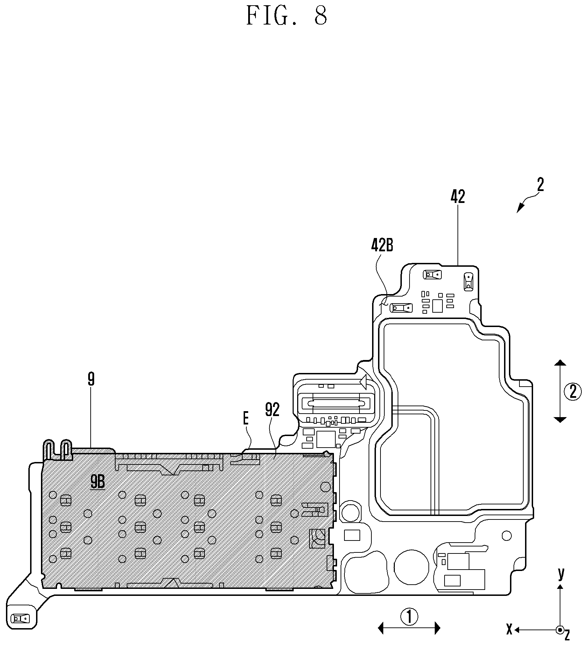

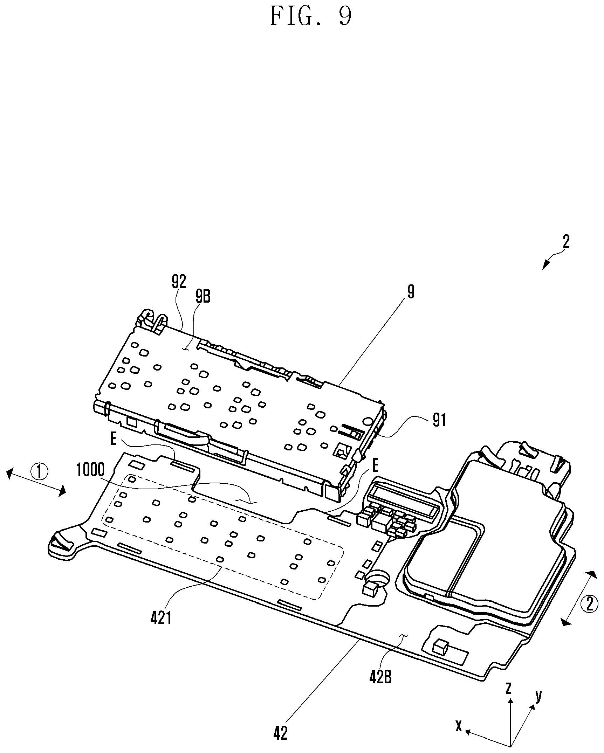

FIG. 6 is a diagram illustrating a portion of a foldable electronic device 2, according to various embodiments of the disclosure. FIG. 7 is a diagram illustrating a portion of a foldable electronic device 2, according to various embodiments of the disclosure. FIG. 8 is a diagram illustrating a portion of a foldable electronic device 2, according to various embodiments of the disclosure. FIG. 9 is an exploded perspective view of a portion of a foldable electronic device 2, according to various embodiments of the disclosure.

It is to be understood that the disclosure contemplates and includes all combinations of the features and/or embodiments disclosed in connection with FIGS. 6, 7, 8, and 9. All combinations of the features described below in connection with FIGS. 6, 7, 8, and 9 may be considered to be included in the disclosure as specific examples.

Referring to FIGS. 6, 7, 8, and 9, the foldable electronic device 2 may include the second PCB 42, the third FPCB 63, and/or the fourth FPCB 64. The foldable electronic device 2 may include the fifth camera module 305. The foldable electronic device 2 may include the first speaker module 71. The foldable electronic device 2 may include a socket 9 (e.g., the second connection terminal 312 in FIG. 2). To help understand the disclosure, the first direction ① is defined as a direction (e.g., a direction parallel to the x-coordinate axis) in which the sixth lateral portion B6 (see FIG. 5) and the eighth lateral portion B8 (see FIG. 5) of the second frame 221 are spaced apart from each other. The first direction ① may be perpendicular to the center line A (e.g., the folding axis) of the foldable electronic device 2 (see FIG. 5). To facilitate understanding of the disclosure, the second direction ② is defined as a direction (e.g., a direction parallel to the y-coordinate axis) in which the second lateral portion B2 (see FIG. 5) and the fourth lateral portion B4 (see FIG. 5) of the second frame 221 are spaced from each other. The second direction ② may be parallel to the center line A (e.g., the folding axis) of the foldable electronic device 2 (see FIG. 5).

According to various embodiments, the second PCB 42 may include a first surface 42A and a second surface 42B. The first surface 42A and the second surface 42B may face in different directions. The first surface 42A of the second PCB 42 may face the second display module 26 (see FIG. 2) (or the second cover 222 in FIG. 2). The first surface 42A may be substantially parallel to the second display module 26 or the second cover 222 in FIG. 2. The second surface 42B of the second PCB 42 may face the second support plate 2211 of the second frame 221 (see FIG. 5) (or the second display area 252 of the first display module 25 in FIG. 2). The second surface 42B may be substantially parallel to the second display area 252 of the first display module 25 in FIG. 2. At least a portion of the second surface 42B may face the second support plate 2211. At least a portion of the second surface 42B may be supported by the second support plate 2211 (see FIG. 5) or may be disposed on or combined with the second support plate 2211.

According to various embodiments, a first FPCB connector 81, a second FPCB connector 82, a third FPCB connector 83, and/or a fourth FPCB connector 84 may be disposed on the second PCB 42. The first FPCB connector 81, the second FPCB connector 82, the third FPCB connector 83, and the fourth FPCB connector 84 may be disposed (e.g., mounted or surface-mounted) on the first surface 42A of the second PCB 42. The first FPCB connector 81 may be electrically connected to the first speaker FPCB 713 of the first speaker module 71. The second FPCB connector 82 may be electrically connected to the third FPCB 63. The third FPCB connector 83 and the fourth FPCB connector 84 may be electrically connected to the fourth FPCB 64.

According to various embodiments, a first counterpart FPCB connector (not shown separately) electrically connected to the first FPCB connector 81 may be disposed (e.g., mounted or surface-mounted) on a first end portion EP1 (also referred to as a first end region) included in the first speaker FPCB 713 of the first speaker module 71. When viewed from above the first surface 42A of the second PCB 42, the first end portion EP1 of the first speaker FPCB 713 may overlap with the second PCB 42. The phrase "when viewed from above the first surface 42A of the second PCB 42" may be understood as "when viewed in a direction perpendicular to the first surface 42A of the second PCB 42", "when viewed from above the second cover 222 (see FIG. 2)", or "when viewed in a direction perpendicular to the second cover 222". The first FPCB connector 81 and the first counterpart FPCB connector may be disposed between the first surface 42A of the second PCB 42 and the first end portion EP1 of the first speaker FPCB 713.

According to various embodiments, a second counterpart FPCB connector (not shown **separately)** electrically connected to the second FPCB connector 82 may be disposed (e.g., mounted or surface-mounted) on a second end portion EP2 (also referred to as a second end region) of the third FPCB 63. When viewed from above the first surface 42A of the second PCB 42, the second end portion EP2 of the third FPCB 63 may overlap with the second PCB 42. The second FPCB connector 82 and the second counterpart FPCB connector may be disposed between the first surface 42A of the second PCB 42 and the second end portion EP2 of the third FPCB 63.

According to various embodiments, a third counterpart FPCB connector (not shown separately) electrically connected to the third FPCB connector 83 may be disposed (e.g., mounted or surface-mounted) on a third end portion EP3 (also referred to as a third end region) of the fourth FPCB 64. A fourth counterpart FPCB connector (not shown separately) electrically connected to the fourth FPCB connector 84 may be disposed (e.g., mounted or surface-mounted) on a fourth end portion EP4 (also referred to as a fourth end region) of the fourth FPCB 64. When viewed from above the first surface 42A of the second PCB 42, the third end portion EP3 and the fourth end portion EP4 of the fourth FPCB 64 may overlap with the second PCB 42. The third FPCB connector 83 and the third counterpart FPCB connector may be disposed between the first surface 42A of the second PCB 42 and the third end portion EP3 of the fourth FPCB 64. The fourth FPCB connector 84 and the fourth counterpart FPCB connector may be disposed between the first surface 42A of the second PCB 42 and the fourth end portion EP4 of the fourth FPCB 64. The fourth FPCB 64 may be provided (or formed) in a form of being extended from the battery overlap portion 641 to each of the third end portion EP3 and the fourth end portion EP4.

According to various embodiments, when viewed from above the first surface 42A of the second PCB 42, the first end portion EP1 of the first speaker FPCB 713 may be located closer to the sixth lateral portion B6 (see FIG. 5) of the second frame 221 in the first direction ① than the second end portion EP2 of the third FPCB 63, the third end portion EP3 of the fourth FPCB 64, and the fourth end portion EP4 of the fourth FPCB 64.

According to various embodiments, when viewed from above the first surface 42A of the second PCB 42, the second end portion EP2 of the third FPCB 63, the third end portion EP3 of the fourth FPCB 64, and the fourth end portion EP4 of the fourth FPCB 64 may be disposed in the first direction ①. The fourth end portion EP4 of the fourth FPCB 64 may be located closer to the eighth lateral portion B8 (see FIG. 5) of the second frame 221 in the first direction ① than the first end portion EP1 of the first speaker FPCB 713, the second end portion EP2 of the third FPCB 63, and the third end portion EP3 of the fourth FPCB 64. When viewed from above the first surface 42A **of the second** PCB 42, the third end portion EP3 of the fourth FPCB 64 may be located between the second end portion EP2 of the third FPCB 63 and the fourth end portion EP4 of the fourth FPCB 64. An end portion group in which the second end portion EP2 of the third FPCB 63, the third end portion EP3 of the fourth FPCB 64, and the fourth end portion EP4 of the fourth FPCB 64 are gathered may be provided.

According to various embodiments, when viewed from above the first surface 42A of the second PCB 42, the end portion group including the second end portion EP2, the third end portion EP3, and the fourth end portion EP4 may be located closer to the second battery 52 (see FIG. 5) in the second direction ② relative to the first end portion EP1 of the first speaker FPCB 713.

According to various embodiments, the fifth camera module 305 may include the fifth camera 3051 and the fifth camera FPCB 3052 extended from the fifth camera 3051. The fifth camera 3051 may be electrically connected to the second PCB 42 through the fifth camera FPCB 3052. When viewed from above the first surface 42A of the second PCB 42, the fifth camera 3051 may not overlap with the second PCB 42. When viewed from above the first surface 42A of the second PCB 42, the fifth camera 3051 may not overlap with the first speaker module 71.

various embodiments, when viewed from above the first surface 42A of the second PCB 42, the fifth camera 3051 of the fifth camera module 305 may be located closer to the second lateral portion B2 (see FIG. 5) of the second frame 221 in the second direction ② than the first end portion EP1 of the first speaker FPCB 713 and the end portion group (e.g., the second end portion EP2, the third end portion EP3, and the fourth end portion EP4) of the plurality of FPCBs (e.g., the third FPCB 63 and the fourth FPCB 64). When viewed from above the first surface 42A of the second PCB 42, the fifth camera 3051 and the end portion group (e.g., the second end portion EP2, the third end portion EP3, and the fourth end portion EP4) may be positioned spaced apart from each other in the second direction ②.

According to various embodiments, when viewed from above the first surface 42A of the second PCB 42, the first speaker 712 of the first speaker module 71 may not overlap with the second PCB 42.

According to various embodiments, when viewed from above the first surface 42A of the second PCB 42, the first speaker 712 of the first speaker module 71 may be located farther from the sixth lateral portion B6 (see FIG. 5) of the second frame 221 than the first end portion EP1 of the first speaker FPCB 713 in the first direction ①. When viewed from above the first surface 42A of the second PCB 42, the first speaker 712 of the first speaker module 71 may be located closer to the sixth lateral portion B6 (see FIG. 5) of the second frame 221 than the fifth camera 3051 of the fifth camera **module** 305 in the first direction ①.

According to various embodiments, when viewed from above the first surface 42A of the second PCB 42, the first speaker 712 of the first speaker module 71 may be located closer to the second side surface B2 (see FIG. 5) of the second frame 221 than the first end portion EP1 of the first speaker FPCB 713 in the second direction ②. When viewed from above the first surface 42A of the second PCB 42, the first speaker 712 of the first speaker module 71 may be located farther from the second side surface B2 (see FIG. 5) of the second frame 221 than the fifth camera 3051 of the fifth camera module 305 in the second direction ②.

According to various embodiments, when viewed from above the first surface 42A of the second PCB 42, the first speaker 712 of the first speaker module 71 may be located closer to the sixth lateral portion B6 (see FIG. 5) of the second frame 221 than the end portion group (e.g., the second end portion EP2, the third end portion EP3, and the fourth end portion EP4) in the first direction ①. When viewed from above the first surface 42A of the second PCB 42, the first speaker 712 of the first speaker module 71 may be located closer to the second lateral portion B2 (see FIG. 5) of the second frame 221 than the end portion group (e.g., the second end portion EP2, the third end portion EP3, and the fourth end portion EP4) in the second direction ②.

According to various embodiments, when viewed from above the first surface 42A of the second PCB 42, the first speaker housing 711 of the first speaker module 71 may be configured to accommodate the first speaker 712 while not overlapping with the first end portion EP1 of the first speaker FPCB 713, the end portion group (e.g., the second end portion EP2, the third end portion EP3, and the fourth end portion EP4), and the fifth camera 3051 of the fifth camera module 305.

According to various embodiments, the first speaker housing 711 of the first speaker module 71 may include a first portion 7111 and a second portion 7112 extended from the first portion 7111. When viewed from above the first surface 42A of the second PCB 42, the first portion 7111 of the first speaker housing 711 may not overlap with the second PCB 42. The first portion 7111 of the first speaker housing 711 may be located between the second support plate 2211 (see FIG. 5) and the second cover 222 (see FIG. 2), and may be disposed on or combined with (e.g., attached to) the second support plate 2211 or supported by the second support plate 2211. The first portion 7111 of the first speaker housing 711 may be located between the second support plate 2211 (see FIG. 5) and the second display module 26 (or the display area of the second display module 26) (see FIG. 2), and may be disposed on or combined with (e.g., attached to) the second support plate 2211 or supported by the second support plate 2211. When viewed from above the first surface 42A of the second PCB 42, the second portion 7112 of the first speaker housing 711 may be extended from the first portion 7111 so as to overlap with the second PCB 42. The second portion 7112 of the first speaker housing 711 may be located between the second PCB 42 and the second cover 222 (see FIG. 2), and may be disposed on or combined with (e.g., attached to) the first surface 42A of the second PCB 42 or supported by the first surface 42A of the second PCB 42. The second portion 7112 of the first speaker housing 711 may be located between the second PCB 42 and the second display module 26 (or the display area of the second display module 26) (see FIG. 2), and may be disposed on or combined with (e.g., attached to) the first surface 42A of the second PCB 42 or supported by the first surface 42A of the second PCB 42. In various embodiments, the second portion 7112 of the first speaker housing 711 may have a smaller thickness than the first portion 7111.

According to various embodiments, the second portion 7112 of the first speaker housing 711 may be disposed on the first surface 42A of the second PCB 42 in an unattached state (also referred to as an uncombined state) with respect to the second PCB 42.

According to various embodiments, the second portion 7112 of the first speaker housing 711 may be disposed on the first surface 42A of the second PCB 42 in an attached state (also referred to as a combined state) with respect to the second PCB 42. For example, the second portion 7112 of the first speaker housing 711 may be combined with (e.g., attached to) the second PCB 42 via an adhesive member (e.g., a double-sided tape) (or an adhesive member) disposed between the second portion 7112 and the first surface 42A of the second PCB 42.

According to various embodiments, the first speaker 712 may be accommodated in the first portion 7111 of the first speaker housing 711.

According to various embodiments, the first speaker housing 711 of the first speaker module 71 may include a sound passage 7113. The first speaker housing 711 may include, for example, an inner wall of the passage (also referred to as a passage inner surface) forming the sound passage 7113. Sound generated by vibration of a diaphragm (not shown separately) of the first speaker 712 may be propagated in the air within the sound passage 7113 and output outside the first speaker housing 711 through the first sound output port 7114. The sound passage 7113 may guide sound generated by the first speaker 712 to be transmitted to the first sound output port 7114. The sound passage 7113 may be implemented so that sound generated by the first speaker 712 proceeds to the first sound output port 7114 without leakage.

According to various embodiments, the first speaker housing 711 of the first speaker module 71 may include a resonance space (or an enclosure providing the resonance space) for the first speaker 712. The resonance space is configured to improve the quality of sound output through the first speaker 712. The resonance space may, for example, enrich mid-low range sound. In various embodiments, the resonance space may be separated from the sound passage 7113. In various embodiments, the first portion 7111 and the second portion 7112 of the first speaker housing 711 may provide the resonance space.

According to various embodiments, the first speaker housing 711 of the first speaker module 71 may include an air vent (not shown separately). The air vent may be configured to allow air to flow between the interior (e.g., the resonance space) of the first speaker housing 711 and the exterior of the first speaker housing 711. The air vent may improve the quality of sound output through the first speaker 712. The air vent may enable rich sound transmission through the first speaker 712. The air vent may enrich mid-low range sound, for example. In various embodiments, the first speaker module 71 may include an air-permeable member (not shown separately) disposed in the air vent. The air-permeable member may reduce or prevent external foreign substances, such as dust or moisture, from flowing into the interior space of the first speaker housing 711 through the air vent. The air-permeability member may include, but is not limited to, a porous member or a mesh member, for example.

According to various embodiments, a socket 9 (e.g., the second connection terminal 312 in FIG. 2) may be disposed on the second surface 42B of the second PCB 42. The socket 9 (also referred to as, for example, the second component 9) may be surface-mounted on the second surface 42B of the second PCB 42. The socket 9 may be, for example, an on-board type. In various embodiments, the socket 9 may be configured to be able to connect an external storage medium (not shown separately) such as an SD card, a SIM card, or a USIM card. The external storage medium may be connected to the socket 9 through a second connection terminal hole formed in the sixth lateral portion B6 (see FIG. 2) of the second frame 221. In various embodiments, the external storage medium may be disposed on a tray (not shown separately). When the tray on which the external storage medium is placed is inserted into the socket 9, the external storage medium may be electrically connected to the second PCB 42 through the socket 9.

According to various embodiments, the socket 9 may include a non-metallic support member 91, a plurality of terminals (not shown separately) disposed on the non-metallic support member 91, and a metal cover 92 coupled with the non-metallic support member 91. The non-metallic support member 91 may include a slot capable of guiding the insertion of an external storage medium. **In** various embodiments, the slot may be provided (or formed) by a combination of the non-metallic support member 91 and the metal cover 92. The plurality of terminals may be electrically connected to a plurality of counterpart terminals of the external storage medium inserted into the slot. The metal cover 92 may be configured to reduce or prevent electromagnetic interference (EMI) to the socket 9 and the external storage medium inserted into the slot. The metal cover 92 may include, for example, a shield can. The socket 9 may include a third surface 9A (e.g., a socket rear surface) (see FIG. 7). The third surface 9A may face the second surface 42B of the second PCB 42 and may be substantially parallel to the second surface 42B. The third surface 9A may be provided (or formed) at least in part by the non-metallic support member 91. The third surface 9A may be provided (or formed) by a combination of the non-metallic support member 91 and the metal cover 92. The socket 9 may include a fourth surface 9B (e.g., a socket front surface) (see FIGS. 8 and 9). The fourth surface 9B may face in an opposite direction to the third surface 9A and in the same direction as the second surface 42B of the second PCB 42. The fourth surface 9B may be located apart from the second surface 42B of the second PCB 42. When viewed from above the second surface 42B of the second PCB 42, the third surface 9A and the fourth surface 9B may overlap. The fourth surface 9B may be provided (or formed) at least in part by the metal cover 92. The fourth surface 9B may be provided (or formed) by a combination of the non-metallic support member 91 and the metal cover 92.

According to various embodiments, the socket 9 may include a pin hole (not shown separately) into which a pin (also called a tray separation pin or tray ejector pin) is inserted to separate the tray supporting the external storage medium from the socket 9. When the pin is inserted into the pin hole, the tray 320 supporting the external storage medium is pushed out from the socket 9 by the force caused by the insertion of the pin and may protrude with respect to the sixth lateral portion B6 (see FIG. 2) of the first frame 211. The tray protruding with respect to the sixth lateral portion B6 (see FIG. 2) may be pulled out from the foldable electronic device 2. The socket 9 may include an actuator (not shown separately) configured to move the tray by using the force transmitted from the pin inserted through the pin hole.

According to various embodiments, the second PCB 42 may include a plurality of conductive pads 421 (also referred to as lands) arranged on the second surface 42B. The socket 9 may be electrically and physically coupled to the second PCB 42 through a conductive adhesive material (or conductive bonding material), such as solder, arranged between the plurality of terminals of the socket 9 and the plurality of conductive pads 421 of the second PCB 42. The external storage medium connected to the socket 9 may be electrically connected to a corresponding electronic component disposed on the second PCB 42 through first conductive pads among the plurality of **conductive** pads 421. The external storage medium connected to the socket 9 may be electrically connected to a ground area (not shown separately) included in the second PCB 42 via at least one second conductive pad among the plurality of conductive pads 421. The metal cover 92 of the socket 9 may be electrically connected to the ground area included in the second PCB 42 via at least one third conductive pad among the plurality of conductive pads 421.

According to various embodiments, when viewed from above the first surface 42A of the second PCB 42, the edge of the second PCB 42 may include a first edge E adjacent to the first speaker 712 of the first speaker module 71 and a second edge other than the first edge E. The first edge E may be, for example, a straight line parallel to the first direction ① when viewed from above the first surface 42A of the second PCB 42, but is not limited thereto. In various embodiments, when viewed from above the first surface 42A of the second PCB 42, the socket 9 may not protrude with respect to the first edge E of the second PCB 42, but is not limited thereto.

According to various embodiments, when viewed from above the first surface 42A of the second PCB 42, the second portion 7112 of the first speaker housing 711 may overlap with the socket 9.

According to various embodiments, when viewed from above the first surface 42A of the second PCB 42, the second PCB 42 may include a first opening 1000 (see FIGS. 7 and 9) overlapping with the socket 9. The first opening 1000 may be configured such that a portion of the third surface 9A of the socket 9 is not covered by the second PCB 42. The first opening 1000 and a portion of the third surface 9A of the socket 9 corresponding to the first opening 1000 may provide (or form) a recess depressed in the direction in which the first surface 42A of the second PCB 42 faces. The socket 9 may not be inserted into the first opening 1000 of the second PCB 42. The third surface 9A of the socket 9 may not be inserted into the first opening 1000 of the second PCB 42.

According to various embodiments, the first opening 1000 of the second PCB 42 may be a notch formed in the first edge E of the second PCB 42. The first opening 1000 is not limited to a notch and may be implemented as an opening, such as a hole (e.g., a through hole) located inside the edge of the second PCB 42 when viewed from above the first surface 42A of the second PCB 42.

According to various embodiments, the first opening 1000 of the second PCB 42 may be configured so as not to have a substantial influence (e.g., electrical influence and structural influence) on the second PCB 42 and the socket 9. The first opening 1000 of the second PCB 42 may be provided (or formed) in a non-conductive area where electrical elements or conductive elements of the second PCB 42 are not arranged (or included). The first opening 1000 of the second PCB 42 may be provided (or formed) so as to avoid, for example, the plurality of conductive pads 421 arranged on the second surface 42B of the second PCB 42 for surface-mounting the socket 9, and/or wiring (e.g., conductive lines as electrical paths) included in the second PCB 42. The first opening 1000 of the second PCB 42 may be formed, for example, in a non-ground area of the second PCB 42 that does not include a ground area. At a level where performance for electrical elements such as the socket 9 can be secured, a portion of the ground area included in the second PCB 42 may be removed for the first opening 1000 of the second PCB 42.

According to various embodiments, when viewed from above the first surface 42A of the second PCB 42, about 2/3 or more of the first opening 1000 of the second PCB 42 may overlap with the third surface 9A of the socket 9, but is not limited thereto.

According to various embodiments, when viewed from above the first surface 42A of the second PCB 42, the first opening 1000 of the second PCB 42 may overlap with the second portion 7112 of the first speaker housing 711. When viewed from above the first surface 42A of the second PCB 42, a portion of the second portion 7112 of the first speaker housing 711 overlaps with the first opening 1000, which is an empty space. However, the first opening 1000 may be defined as a component of the second PCB 42, and a portion of the second portion 7112 of the first speaker housing 711 corresponding to the first opening 1000 may be understood to overlap with the second PCB 42.

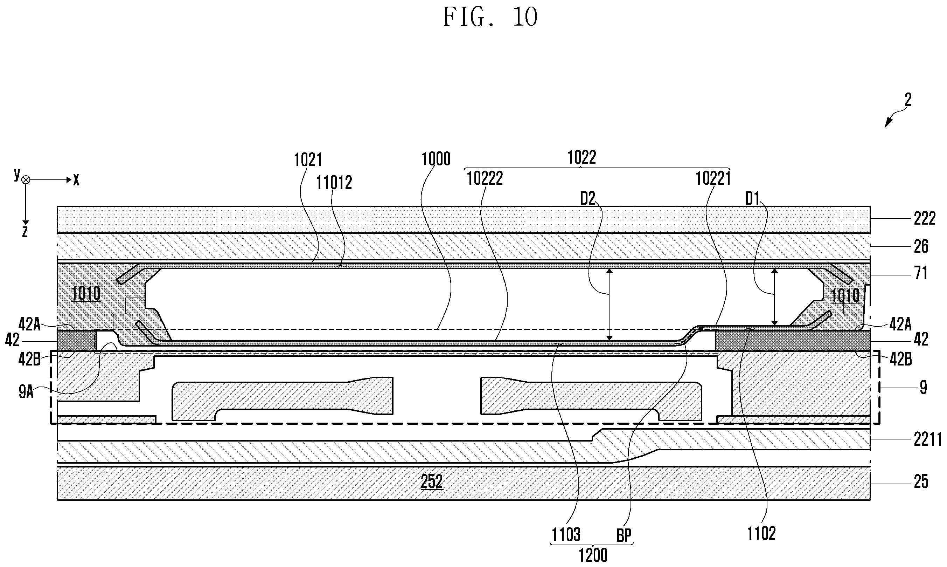

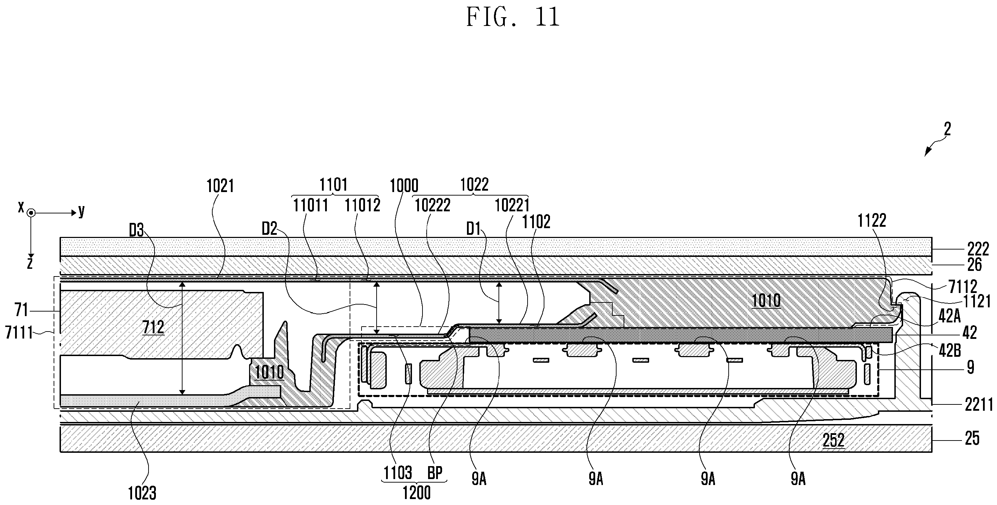

According to various embodiments, the second portion 7112 of the first speaker housing 711 may be disposed on the second surface 42B of the second PCB 42, and a portion of the second portion 7112 may be located in the first opening 1000 of the second PCB 42. The second portion 7112 may include, for example, a protrusion (e.g., the protrusion 1200 in FIGS. 10 and 11) configured to be inserted into the first opening 1000 of the second PCB 42. The protrusion of the second portion 7112 may expand an internal space (e.g., a resonance space) of the first speaker housing 711 as compared to a comparative example in which the protrusion and the first opening 1000 of the second PCB 42 are omitted. In various embodiments, the resonance space of the first speaker housing 711 may be expanded by the protrusion of the second portion 7112, so that the quality of sound output through the first speaker 712 may be improved compared to a comparative example in which the protrusion and the first opening 1000 of the second PCB 42 are omitted. The protrusion of the second portion 7112 may, for example, enrich the mid-low range sound compared to a comparative example in which the protrusion and the first opening 1000 of the second PCB 42 are omitted.

**According** to various embodiments, positioning the protrusion (e.g., the protrusion 1200 in FIGS. 10 and 11) of the second portion 7112 of the first speaker housing 711 in the first opening 1000 of the second PCB 42 may not only expand the size of the second battery 52 in the second direction ②, but also secure the resonance space of the first speaker module 71 while reducing space constraints caused by the expansion of the size of the second battery 52.

According to various embodiments, the protrusion (e.g., the protrusion 1200 in FIGS. 10 and 11) may be understood as being included in the first portion 7111 of the first speaker housing 711, in which case the first opening 1000 is defined as a separate component from the second PCB 42, and the second PCB 42 may be understood as an object having a substantial volume.

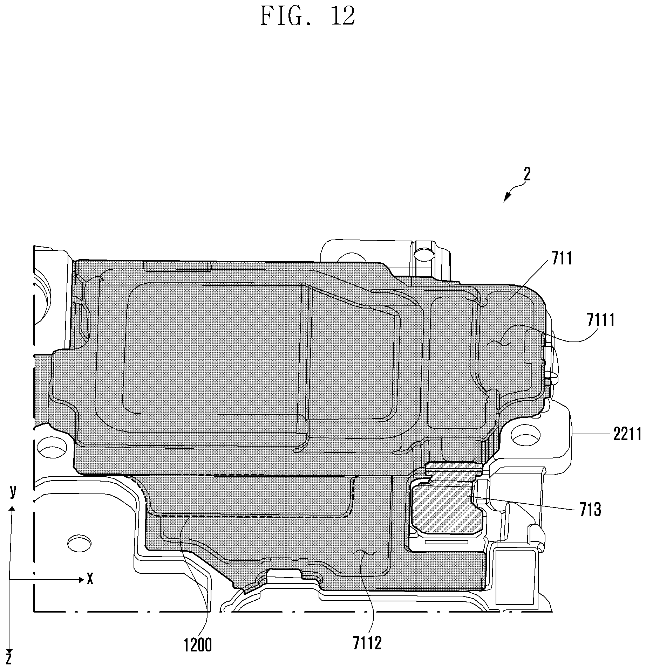

FIG. 10 is a cross-sectional view of a portion of a foldable electronic device 2 taken along line FF' of FIG. 6, according to various embodiments of the disclosure. FIG. 11 is a cross-sectional view of a portion of a foldable electronic device 2 taken along line GG' of FIG. 6, according to various embodiments of the disclosure. FIG. 12 is a perspective view of a portion of a foldable electronic device 2, according to various embodiments of the disclosure.

It is to be understood that the disclosure contemplates and includes all combinations of the features and/or embodiments disclosed in connection with FIGS. 10, 11, and 12. All combinations of the features described below in connection with FIGS. 10, 11, and 12 may be considered to be included in the disclosure as specific examples.

Referring to FIGS. 10, 11, and 12, the foldable electronic device 2 may include the second support plate 2211. The foldable electronic device 2 may include the first display module 25 and/or the second display module 26. The foldable electronic device 2 may include the second cover 222. The foldable electronic device 2 may include the second PCB 42, the first speaker module 71, and/or the socket 9.

According to various embodiments, the second display area 252 of the first display module 25 may be disposed on or combined with the second support plate 2211.

According to various embodiments, the second display module 26 may be located between the second cover 222 and the second support plate 2211. The second display module 26 may be disposed on or combined with the second cover 222.

According to various embodiments, the second PCB 42 may be located between the second display module 26 and the second support plate 2211. The second PCB 42 may be disposed on or combined with the second support plate 2211.

According to various embodiments, the first speaker module 71 may include the first speaker housing 711, and the first speaker 712 located within the first speaker housing 711. The first speaker housing 711 may include the first portion 7111 and the second portion 7112 extended from the first portion 7111. When viewed from above the first surface 42A of the second PCB 42, the first portion 7111 of the first speaker housing 711 may not overlap with the second PCB 42. The first portion 7111 of the first speaker housing 711 may be located between the second support plate 2211 and the second cover 222, and may be disposed on or combined with the second support plate 2211. The first portion 7111 of the first speaker housing 711 may be combined with the second support plate 2211 via, for example, a mechanical fastening such as screw fastening, or bonding. The first portion 7111 of the first speaker housing 711 may be located between the second support plate 2211 and the second display module 26 (or the display area of the second display module 26), and may be disposed on or combined with (e.g., attached to) the second support plate 2211 or supported by the second support plate 2211. When viewed from above the first surface 42A of the second PCB 42, the second portion 7112 of the first speaker housing 711 may be extended from the first portion 7111 of the first speaker housing 711 so as to overlap with the second PCB 42. The second portion 7112 of the first speaker housing 711 may be located between the second PCB 42 and the second cover 222 (see FIG. 2), and may be disposed on or combined with (e.g., attached to) the first surface 42A of the second PCB 42 or supported by the first surface 42A of the second PCB 42. The second portion 7112 of the first speaker housing 711 may be located between the second PCB 42 and the second display module 26 (or the display area of the second display module 26), and may be disposed on the first surface 42A of the second PCB 42 or supported by the first surface 42A of the second PCB 42.

According to various embodiments, the first speaker housing 711 may be combined with the second support plate 2211 via a mechanical fastening (not shown) such as a screw fastening or a snap-fit fastening. The snap-fit fastening is, for example, a fastening structure that resiliently combines interlocking elements of the first speaker housing 711 (e.g., a non-metallic frame 1010 of the first speaker housing 711) and the second support plate 2211. For example, the second support plate 2211 may include a hook structure 1121, and the first speaker housing 711 may include a hook fastening portion 1122 corresponding to the hook structure 1121.

According to various embodiments, the first speaker 712 may be accommodated in the first portion 7111 of the first speaker housing 711.

According to various embodiments, the first speaker housing 711 may include the non-metallic frame 1010 (also referred to as a non-metallic support member), a first metal plate 1021, a second metal plate 1022, and/or a third metal plate 1023. The non-metallic frame 1010 may be a basic structure designed to withstand a load. The first metal plate 1021, the second metal plate 1022, and the third metal plate 1023 may be disposed on or combined with the non-metallic frame 1010. The exterior appearance of the first speaker housing 711 may be provided (or formed) by a combination of the non-metallic frame 1010, the first metal plate 1021, the second metal plate 1022, and the third metal plate 1023. The locations or number of metal plates arranged on the non-metallic frame 1010 is not limited to the illustrated example.

According to various embodiments, the first metal plate 1021 of the first speaker housing 711 may be located at least in part between the second display module 26 and the first speaker 712. When viewed from above the second cover 222, the first metal plate 1021 may overlap with the first speaker 712. When viewed from above the second cover 222, the first metal plate 1021 may overlap with the first speaker 712.

According to various embodiments, the non-metallic frame 1010 of the first speaker housing 711 may include a second opening. The first metal plate 1021 may be disposed on or combined with the non-metallic frame 1010 to block the second opening. The first metal plate 1021 may reduce or prevent sound generated by the first speaker 712 from leaking out of the first speaker housing 711 through the second opening of the non-metallic frame 1010. The second opening may allow the combination of the non-metallic frame 1010 and the first metal plate 1021 to have a slim structure. The first metal plate 1021 may provide (or form) an inner surface that defines the internal space (e.g., the resonance space) of the first speaker housing 711. The first metal plate 1021 may be a thin plate for slimming the first speaker module 71, and may also have strength (e.g., vibration-proof strength) that may reduce vibrations from sound generated from the first speaker 712 and ensure durability. In various embodiments, the second opening of the non-metal frame 1010 corresponding to the first metal plate 1021 may be omitted.

According to various embodiments, the first metal plate 1021 of the first speaker housing 711 may reduce or prevent electromagnetic interference (EMI) to the first speaker 712. The first metal plate 1021 may reduce or prevent magnetic force from the first speaker 712 from being transmitted or moved to the outside of the first speaker module 71. The first metal plate 1021 may include an electromagnetic shielding material or an electromagnetic absorbing material.

According to various embodiments, the first metal plate 1021 of the first speaker housing 711 may reduce or prevent an electromagnetic influence (e.g., electromagnetic interference (EMI)) of the first speaker 712 on the second display module 26. Advantageously, the first metal plate 1021 may reduce or prevent a degradation of the performance of the second display module 26 caused by the first speaker 712. The first metal plate 1021 may reduce or prevent magnetic force from the first speaker 712 from being transmitted or moved to the second display module 26.

According to various embodiments, the first metal plate 1021 of the first speaker housing 711 may be disposed at least in part between an electromagnetic induction panel (not shown separately) included or disposed in the second display module 26 and the first speaker 712. When viewed from above the second cover 222, the first metal plate 1021 may overlap with the electromagnetic induction panel and the first speaker 712. The first metal plate 1021 may reduce or prevent an electromagnetic influence (e.g., EMI) that the first speaker 712 exerts on the electromagnetic induction panel. The first metal plate 1021 may reduce or prevent a magnetic force from the first speaker 712 from being transmitted or moved to the electromagnetic induction panel, thereby reducing or preventing a degradation in the performance of the electromagnetic induction panel.

According to various embodiments, the first metal plate 1021 of the first speaker housing 711 may include various metal materials capable of shielding magnetic force. The first metal plate 1021 may include, for example, steel plate cold commercial (SPCC), but is not limited thereto.

According to various embodiments, the first metal plate 1021 of the first speaker housing 711 may be electrically connected to a ground area (not shown separately) included in the second PCB 42 and may be understood as a part of the ground structure of the foldable electronic device 2.

According to various embodiments, the first metal plate 1021 of the first speaker housing 711 may be electrically connected to a metal sheet (also referred to as a metal layer) (e.g., a copper sheet) (not shown separately) of an electromagnetic shielding material that provides (or forms) the rear surface of the second display module 26, and may be understood as a part of the ground structure of the foldable electronic device 2. The first metal plate 1021 may be electrically connected to the metal sheet through a conductive adhesive member or a flexible conductive member disposed between the first metal plate 1021 and the metal sheet.

According to various embodiments, the first metal plate 1021 of the first speaker housing 711 may be in an electrically floating state. The first metal plate 1021 may be electrically and physically isolated from surrounding conductors, such as, for example, the second metal plate 1022 and the third metal plate 1023.

According to various embodiments, the first metal plate 1021 of the first speaker housing 711 may be extended from the first portion 7111 of the first speaker housing 711 to the second portion 7112. When viewed from above the second cover 222, the first metal plate 1021 may overlap with the second PCB 42 in the second portion 7112 of the first speaker housing 711. When viewed from above the second cover 222, the first metal plate 1021 may overlap with the first speaker 712 in the first portion 7111 of the first speaker housing 711. When viewed from above the second cover 222, the first metal plate 1021 may overlap with the socket 9 disposed on the second surface 42B of the second PCB 42 in the second portion 7112 of the first speaker housing 711.

According to various embodiments, the first metal plate 1021 may include a first planar portion 1101 substantially parallel to the second cover 222 or the second PCB 42. When viewed from above the second cover 222, the first planar portion 1101 of the first metal plate 1021 may be extended from a first region 11011 located in the first portion 7111 of the first speaker housing 711 to a second region 11012 located in the second portion 7112 of the first speaker housing 711. When viewed from above the second cover 222, the first region 11011 of the first planar portion 1101 may overlap with the first speaker 712 in the first portion 7111 of the first speaker housing 711. When viewed from above the second cover 222, the second region 11012 of the first planar portion 1101 may overlap with the socket 9 disposed on the second surface 42B of the second PCB 42 in the second portion 7112 of the first speaker housing 711.

According to various embodiments, the second metal plate 1022 of the first speaker housing 711 may be disposed on or combined with the non-metallic frame 1010 so as to face the first surface 42A of the second PCB 42 and so as to face the third surface 9A of the socket 9 through the first opening 1000 of the second PCB 42.

According to various embodiments, the non-metallic frame 1010 of the first speaker housing 711 may include a third opening. The second metal plate 1022 may be disposed on or combined with the non-metallic frame 1010 to block the third opening. Advantageously, the second metal plate 1022 may reduce or prevent sound generated by the first speaker 712 from leaking out of the first speaker housing 711 through the third opening of the non-metallic frame 1010. The third opening may allow the combination of the non-metallic frame 1010 and the second metal plate 1022 to have a slim structure. The second metal plate 1022 may provide (or form) an inner surface that defines the internal space (e.g., the resonance space) of the first speaker housing 711. The second metal plate 1022 may be a thin plate for slimming the first speaker module 71, and may have strength (e.g., dustproof strength) that may reduce vibrations for sound generated from the first speaker 712 and ensure durability. In various embodiments, the third opening of the non-metallic frame 1010 corresponding to the second metal plate 1022 may be omitted. In various embodiments, the non-metallic frame 1010 may be provided (or formed) in an expanded form with respect to the omission of the second metal plate 1022 and the third opening.

According to various embodiments, the second metal plate 1022 of the first speaker housing 711 may reduce or prevent electromagnetic interference (EMI) to the first speaker 712. The second metal plate 1022 may reduce or prevent magnetic force from the first speaker 712 from being transmitted or moved to the outside of the first speaker module 71. The second metal plate 1022 may include an electromagnetic shielding material or an electromagnetic absorbing material.

According to various embodiments, the second metal plate 1022 of the first speaker housing 711 may reduce or prevent an electromagnetic influence (e.g., electromagnetic interference (EMI)) of the first speaker 712 to the second PCB 42 or electrical elements (e.g., the socket 9) disposed on the second PCB 42. The second metal plate 1022 may reduce or prevent magnetic force from the first speaker 712 from being transmitted or moved to the second PCB 42 or electrical elements disposed on the second PCB 42. The second metal plate 1022 may include various metallic materials capable of shielding the magnetic force. The second metal plate 1022 may include, for example, but is not limited to, SPCC.

According to various embodiments, the second metal plate 1022 of the first speaker housing 711 may be electrically connected to a ground area (not shown separately) included in the second PCB 42 and may be understood as a part of the ground structure of the foldable electronic device 2.

According to various embodiments, the second metal plate 1022 of the first speaker housing 711 may be in an electrically floating state.

According to various embodiments, the second metal plate 1022 may include a first partial plate region 10221 facing the first surface 42A of the second PCB 42, and a second partial plate region 10222 configured to face the third surface 9A of the socket 9 through the first opening 1000 of the second PCB 42. The first partial plate region 10221 of the second metal plate 1022 may be located between the first metal plate 1021 and the second PCB 42. When viewed from above the second cover 222, the first metal plate 1021 (e.g., the first planar portion 1101 of the first metal plate 1021) may overlap with the first partial plate region 10221 of the second metal plate 1022. The first partial plate region 10221 of the second metal plate 1022 may include, for example, a second planar portion 1102 that is parallel to the first planar portion 1101 of the first metal plate 1021. The second partial plate region 10222 of the second metal plate 1022 may be located between the first metal plate 1021 and the socket 9. When viewed from above the second cover 222, the first metal plate 1021 (e.g., the first planar portion 1101 of the first metal plate 1021) may overlap with the second partial plate region 10222 of the second metal plate 1022. The second partial plate region 10222 of the second metal plate 1022 may include, for example, a third planar portion 1103 that is parallel to the first planar portion 1101 of the first metal plate 1021. In various embodiments, in the direction in which the second surface 42B of the second PCB 42 faces, the third planar portion 1103 of the second metal plate 1022 may be spaced further from the first planar portion 1101 of the first metal plate 1021 than the second planar portion 1102 of the second metal plate 1022. The second metal plate 1022 may include a bending portion (BP) extending the second planar portion 1102 and the third planar portion 1103.

According to various embodiments, the third planar portion 1103 of the second metal plate 1022 may be in physical contact with the third surface 9A of the socket 9 disposed (e.g., surface-mounted) on the second surface 42B of the second PCB 42 through the first opening 1000 of the second PCB 42. The third surface 9A of the socket 9 may support the third planar portion 1103 of the second metal plate 1022.

According to various embodiments, the third planar portion 1103 of the second metal plate 1022 may be disposed on the first surface 42A of the second PCB 42 in an unattached state (also referred to as an uncombined state) with respect to the second PCB 42.

According to various embodiments, the third planar portion 1103 of the second metal plate 1022 may be disposed on the first surface 42A of the second PCB 42 in an attached state (also referred to as a combined state) with respect to the second PCB 42. For example, the third planar portion 1103 of the second metal plate 1022 may be combined with (e.g., attached to) the second PCB 42 via an adhesive member (e.g., a double-sided tape) (or an adhesive member) disposed between the second portion 7112 and the first surface 42A of the second PCB 42.

According to various embodiments, the third planar portion 1103 of the second metal plate 1022 may be inserted into the first opening 1000 of the second PCB 42 and may be physically spaced (e.g., not in contact) from the third surface 9A of the socket 9 disposed (e.g., surface-mounted) on the second surface 42B of the second PCB 42.

According to various embodiments, the third metal plate 1023 of the first speaker housing 711 may be located at least in part between the second support plate 2211 and the first speaker 712. When viewed from above the second cover 222, the third metal plate 1023 may overlap with the first speaker 712. When viewed from above the second cover 222, the third metal plate 1023 may overlap with the first speaker 712.

According to various embodiments, the non-metallic frame 1010 of the first speaker housing 711 may include a fourth opening. The third metal plate 1023 may be disposed on or combined with the non-metallic frame 1010 to block the fourth opening. Advantageously, the third metal plate 1023 may reduce or prevent sound generated by the first speaker 712 from leaking out of the first speaker housing 711 through the fourth opening of the non-metallic frame 1010. The third opening may allow the combination of the non-metallic frame 1010 and the third metal plate 1023 to have a slim structure. The third metal plate 1023 may provide (or form) an inner surface that defines the internal space (e.g., the resonance space) of the first speaker housing 711. In various embodiments, the fourth opening of the non-metallic frame 1010 corresponding to the third metal plate 1023 may be omitted. In various embodiments, the non-metallic frame 1010 may be provided (or formed) in an expanded form with respect to the omission of the third metal plate 1023 and the fourth opening.

According to various embodiments, the third metal plate 1023 of the first speaker housing 711 may reduce or prevent electromagnetic interference (EMI) to the first speaker 712. The third metal plate 1023 may reduce or prevent magnetic force from the first speaker 712 from being transmitted or moved to the outside of the first speaker module 71. The third metal plate 1023 may include an electromagnetic shielding material or an electromagnetic absorbing material. In various embodiments, the third metal plate 1023 may include various metal materials capable of shielding magnetic force. The third metal plate 1023 may include, for example, but is not limited to, SPCC.

According to various embodiments, the third metal plate 1023 of the first speaker housing 711 may be electrically connected to a ground area (not shown separately) included in the second PCB 42 and may be understood as a part of the ground structure of the foldable electronic device 2.

According to various embodiments, the third metal plate 1023 of the first speaker housing 711 may be in an electrically floating state.

According to various embodiments, the third metal plate 1023 of the first speaker housing 711 may be located on the first portion 7111 of the first speaker housing 711. When viewed from above the second cover 222, the third metal plate 1023 may overlap with the first metal plate 1021 and the first speaker 712 in the first portion 7111 of the first speaker housing 711.

According to various embodiments, the diaphragm (not shown separately) of the first speaker 712 may face the third metal plate 1023 of the first speaker housing 711. The first speaker 712 may generate sound toward the third metal plate 1023. The third metal plate 1023 may be a thin plate for slimming the first speaker module 71, and have a strength that not only reduces vibrations from sound generated by the first speaker 712 but also ensures durability.

According to various embodiments, in the direction in which the second surface 42B of the second PCB 42 faces, the second planar portion 1102 of the first partial plate region 10221 of the second metal plate 1022 may be spaced apart from the first planar portion 1101 of the first metal plate 1021 by a first distance D1. The first speaker housing 711 may have a first gap of a first thickness (e.g., a thickness corresponding to the first distance D1) between the first planar portion 1101 of the first metal plate 1021 and the second planar portion 1102 of the first partial plate region 10221 of the second metal plate 1022 in the second portion 7112.

According to various embodiments, in the direction in which the second surface 42B of the second PCB 42 faces, the third planar portion 1103 of the second partial plate region 10222 of the second metal plate 1022 may be spaced apart from the first planar portion 1101 of the first metal plate 1021 by a second distance D2. The first speaker housing 711 may have a second gap of a second thickness (e.g., a thickness corresponding to the second distance D2) between the first planar portion 1101 of the first metal plate 1021 and the third planar portion 1103 of the second partial plate region 10222 of the second metal plate 1022 in the second portion 7112. The second distance D2 at which the third planar portion 1103 of the second partial plate region 10222 of the second metal plate 1022 is spaced apart from the first planar portion 1101 of the first metal plate 1021 in the second portion 7112 of the first speaker housing 711 may be greater than the first distance D1 at which the second planar portion 1102 of the first partial plate region 10221 of the second metal plate 1022 is spaced apart from the first planar portion 1101 of the first metal plate 1021 in the second portion 7112 of the first speaker housing 711.

According to various embodiments, the second partial plate region 10222 of the second metal plate 1022 of the first speaker housing 711 may have a protrusion 1200 that protrudes with respect to the first partial plate region 10221 of the second metal plate 1022 to be inserted into the first opening 1000 of the second PCB 42. The protrusion 1200 of the second metal plate 1022 may include a bending portion (BP) between the first partial plate region 10221 and the second partial plate region 10222, and the third planar portion 1103 configured to face the third surface 9A of the socket 9 through the first opening 1000 of the second PCB 42. The protrusion 1200 of the second metal plate 1022 may expand the internal space (e.g., the resonance space) of the first speaker housing 711 compared to a comparative example in which the protrusion 1200 and the first opening 1000 of the second PCB 42 are omitted. Advantageously, since the resonance space of the first speaker housing 711 is expanded by the protrusion 1200 of the second metal plate 1022, the quality of sound output through the first speaker 712 may be improved compared to the comparative example in which the protrusion 1200 and the first opening 1000 of the second PCB 42 are omitted. The protrusion 1200 of the second metal plate 1022 may enrich the mid-low range sound, for example, compared to the comparative example in which the protrusion 1200 and the first opening 1000 of the second PCB 42 are omitted.

According to various embodiments, the protrusion 1200 of the second metal plate 1022 may expand the resonance space by, for example, about 0.03 cubic centimeters (cc), compared to the comparative example in which the protrusion 1200 and the first opening 1000 of the second PCB 42 are omitted. For example, in the comparative example in which the protrusion 1200 and the first opening 1000 of the second PCB 42 are omitted, the resonance space of the first speaker housing 711 may be about 0.37 cc. The first speaker housing 711 according to the disclosure may have, for example, the resonance space of about 0.40 cc, compared to the comparative example, by adding the expanded resonance space due to the protrusion 1200 of the second metal plate 1022.

According to various embodiments, the second metal plate 1022 may be omitted and the non-metallic frame 1010 may be extended to replace the second metal plate 1022.

According to various embodiments, although not shown separately, an integrated or single plate may be provided (or formed) replacing the second metal plate 1022 and the third metal plate 1023.

According to various embodiments, in the direction in which the second surface 42B of the second PCB 42 faces, the third metal plate 1023 may be spaced apart from the first planar portion 1101 of the first metal plate 1021 by a third distance D3. The first speaker housing 711 may have a third gap of a third thickness (e.g., a thickness corresponding to the third distance D3) between the first metal plate 1021 and the third metal plate 1023 in the first portion 7111. The third distance D3 at which the third metal plate 1023 is spaced from the first planar portion 1101 of the first metal plate 1021 in the first portion 7111 of the first speaker housing 711 may be greater than the second distance D2 at which the third planar portion 1103 of the second partial plate region 10222 of the second metal plate 1022 is spaced from the first planar portion 1101 of the first metal plate 1021 in the second portion 7112 of the first speaker housing 711.

According to various embodiments, the first speaker module 71 may be understood as a "first component", and the socket 9 may be understood as a "second component". The first component may be various and not limited to the first speaker module 71. The first component may be disposed at least in part on a PCB (e.g., the second PCB 42). The first component may include a first electrical element. The first electrical element may be, for example, one of a plurality of components included in the electronic device 101 of FIG. 1, but is not limited thereto. The first component may further include a first structural element (e.g., a support member) that supports the first electrical element or is combined with the first electrical element. The second component may be various and not limited to the socket 9. In various embodiments, the first component may be surface-mounted on a PCB (e.g., the second PCB 42). The second component may include a second electrical element. The second electrical element may be, for example, but is not limited to, one of the plurality of components included in the electronic device 101 of FIG. 1. The second component may further include a second structural element (e.g., a support member) that supports the second electrical element or is combined with the second electrical element. The second PCB 42 is not limited in the disclosure.

According to various embodiments, a portion of the second component may be inserted into the first opening 1000 of the second PCB 42. A portion of the first component inserted into the first opening 1000 of the second PCB 42 may face a portion of the second component inserted into the first opening 1000 of the second PCB 42.

According to various embodiments, an opening of a PCB (e.g., the first opening 1000 of the second PCB 42) may also be utilized as a space where an FPCB is located.

According to various embodiments, the opening of the PCB (e.g., the first opening 1000 of the second PCB 42) may also be utilized as a space for a conductive member, such as a conductive gasket, that is included in an electrical path (e.g., a feed line) between an antenna radiator and a wireless communication circuit (e.g., the wireless communication module 192 in FIG. 1), or an electrical path (e.g., a ground line) between an antenna radiator and a ground area of the second PCB 42.

According to various embodiments, the opening of the PCB (e.g., the first opening 1000 of the second PCB 42) may also be utilized as an empty space for weight saving. The opening of the PCB may be utilized for various other purposes.

According to various embodiments, although not illustrated separately, the technical features of the disclosure may be applied to electronic devices of other external shapes (e.g., a bar type electronic device, a plate type electronic device, a slidable electronic device, a stretchable electronic device, or a rollable electronic device) that are not limited to the foldable electronic device 2.

According to various embodiments of the disclosure, an electronic device (e.g., the foldable electronic device 2) includes a printed circuit board (PCB) (e.g., the second PCB 42), a first component (e.g., the first speaker module 71), and a second component (e.g., the socket 9). The first component is disposed on a first surface (e.g., the first surface 42A). The second component is disposed on a second surface (e.g., the second surface 42B) of the PCB facing in an opposite direction to the first surface. The PCB includes an opening (e.g., the first opening 1000) formed between the first component and the second component. The first component includes a protrusion (e.g., the protrusion 1200) configured to be inserted into the opening of the PCB and face the second component.

According to various embodiments of the disclosure, the second component (e.g., the socket 9) may include a third surface (e.g., the third surface 9A) facing the second surface (e.g., the second surface 42B) of the PCB (e.g., the second PCB 42). The protrusion (e.g., the protrusion 1200) of the first component (e.g., the first speaker module 71) may face a part of the third surface of the second component through the opening (e.g., the first opening 1000) of the PCB. When viewed from above the first surface (e.g., the first surface 42A) of the PCB, about two-thirds or more of the opening of the PCB may overlap with the third surface of the second component.

According to various embodiments of the disclosure, the first component (e.g., the first speaker module 71) may be disposed on the first surface (e.g., the first surface 42A) of the PCB (e.g., the second PCB 42) in an unattached state with respect to the PCB. The second component (e.g., the socket 9) may be surface-mounted on the second surface (e.g., the second surface 42B) of the PCB.

According to various embodiments of the disclosure, the first component (e.g., the first speaker module 71) may be disposed on the first surface (e.g., the first surface 42A) of the PCB (e.g., the second PCB 42) in an attached state with respect to the PCB. The second component (e.g., the socket 9) may be surface-mounted on the second surface (e.g., the second surface 42B) of the PCB.

According to various embodiments of the disclosure, the opening (e.g., the first opening 1000) of the PCB (e.g., the second PCB 42) may include a notch formed at an edge (e.g., the first edge E) of the PCB when viewed from above the first surface (e.g., the first surface 42A) of the PCB.

According to various embodiments of the disclosure, the opening (e.g., the first opening 1000) of the PCB (e.g., the second PCB 42) may include a hole located inside the edge of the PCB when viewed from above the first surface (e.g., the first surface 42A) of the PCB.

According to various embodiments of the disclosure, the first component (e.g., the speaker module 71) may be extended from a first portion (e.g., the first portion 7111) not overlapping with the PCB (e.g., the second PCB 42) to a second portion (e.g., the second portion 7112) overlapping with the PCB when viewed from above the first surface (e.g., the first surface 42A) of the PCB. The second portion of the first component may include the protrusion (e.g., the protrusion 1200) inserted into the opening (e.g., the first opening 1000) of the PCB.

According to various embodiments of the disclosure, the first component may include a speaker module (e.g., the first speaker module 71) including a speaker housing (e.g., the speaker housing 711) and a speaker (e.g., the speaker 712) located within the speaker housing. A portion of the speaker housing may include the protrusion (e.g., the protrusion 1200) inserted into the opening (e.g., the first opening 1000) of the PCB (e.g., the second PCB 42).

According to various embodiments of the disclosure, the speaker housing (e.g., the speaker housing 711) may be extended from a first portion (e.g., the first portion 7111) not overlapping with the PCB (e.g., the second PCB 42) to a second portion (e.g., the second portion 7112) overlapping with the PCB when viewed from above the first surface (e.g., the first surface 42A) of the PCB. The speaker (e.g., the first speaker 712) may be located in the first portion of the speaker housing. The first portion and the second portion of the speaker housing may form a resonance space for the speaker. The second portion of the speaker housing may include the protrusion (e.g., the protrusion 1200) inserted into the opening (e.g., the first opening 1000) of the PCB.

According to various embodiments of the disclosure, the electronic device (e.g., the foldable electronic device 2) may further include a battery (e.g., the second battery 52) located in the electronic device. When viewed from above the first surface (e.g., the first surface 42A) of the PCB (e.g., the second PCB 42), the second portion (e.g., the second portion 7112) of the speaker housing (e.g., the first speaker 711) may be located between the speaker (e.g., the first speaker 712) and the battery.

According to various embodiments of the disclosure, the speaker housing (e.g., the first speaker housing 711) may include a metal plate (e.g., the second metal plate 1022) that forms at least in part the protrusion (e.g., the protrusion 1200) inserted into the opening (e.g., the first opening 1000) of the PCB (e.g., the second PCB 42). The metal plate may be configured to define a portion of the resonance space of the speaker housing.

According to various embodiments of the disclosure, the electronic device (e.g., the foldable electronic device 2) may further include a display module (e.g., the second display module 26) and a support plate (e.g., the second support plate 2211). The PCB (e.g., the second PCB 42) and the speaker module (e.g., the first speaker module 71) may be located between the display module and the support plate. The first surface (e.g., the first surface 42A) of the PCB may face the display module. The second surface (e.g., the second surface 42B) of the PCB may face the support plate.

According to various embodiments of the disclosure, the speaker housing (e.g., the first speaker housing 711) may include a first metal plate (e.g., the first metal plate 1021) and a second metal plate (e.g., the second metal plate 1022). The first metal plate may include a first planar portion (e.g., the first planar portion 1101) extended from a first region (e.g., the first region 11011) not overlapping with the PCB (e.g., the second PCB 42) to a second region (e.g., the second region 11012) overlapping with the PCB when viewed from above the first surface (e.g., the first surface 42A) of the PCB. The second metal plate may include a first partial plate region (e.g., the first partial plate region 10221) and a second partial plate region (e.g., the second partial plate region 10222). The first partial plate region may be located between the second region of the first metal plate and the first surface of the PCB, and include a second planar portion (e.g., the second planar portion 1102) facing the first surface of the PCB. The second partial plate region may be extended from the first partial plate region, and include a third planar portion (e.g., the third planar portion 1103) facing the second component (e.g., the socket 9) through the opening (e.g., the first opening 1000) of the PCB. The speaker (e.g., the first speaker 712) may be located within the speaker housing so as to overlap with the first region of the first planar portion when viewed from above the first surface of the PCB. The first planar portion, the second planar portion, and the third planar portion may define a resonance space of the speaker housing. A second distance (e.g., the second distance D2) by which the third planar portion is spaced from the second region of the first planar portion is greater than a first distance (e.g., the first distance D1) by which the second planar portion is spaced from the second region of the first planar portion.

According to various embodiments of the disclosure, the second component may include a socket (e.g., the socket 9) configured to connect a subscriber identity module (SIM) card.

According to various embodiments of the disclosure, the opening (e.g., the first opening 1000) of the PCB (e.g., the second PCB 42) may be formed in a non-ground area of the PCB (42).

Additionally, it will be understood that any embodiment(s) described herein can be used in conjunction with any other embodiment(s) described herein. In particular, it is emphasized that although the disclosure has been presented in a form that provides a number of embodiments each defining a number of features, some of these embodiments are connected only by reference to the same drawing or drawings. It should be understood that the disclosure includes all combinations of these embodiments, unless there is an apparent contradiction between two (or more) embodiments. That is, if features are presented as optional in the disclosure, all combinations of such optional features are included in the disclosure.

## Claims

1. An electronic device (2) comprising:
a printed circuit board, PCB, (42);
a first component (71) disposed on a first surface (42A) of the PCB (42); and
a second component (9) disposed on a second surface (42B) of the PCB (42) facing in an opposite direction to the first surface (42A),
wherein the PCB (42) includes an opening (1000) formed between the first component (71) and the second component (9);
**characterized in that**
the first component (71) is a speaker module including a speaker housing (711) and a speaker (712) located within the speaker housing (711),
the speaker housing (711) is extended from a first portion (7111) not overlapping with the PCB (42) to a second portion (7112) overlapping with the PCB (42) when viewed from above the first surface (42A) of the PCB (42),
the speaker (712) is located in the first portion (7111) of the speaker housing (711),
the first portion (7111) and the second portion (7112) of the speaker housing (711) form a resonance space for the speaker (712), and
the second portion (7112) of the speaker housing (711) includes a protrusion (1200) configured to be inserted into the opening (1000) of the PCB (42) and face the second component (9).

2. The electronic device (2) of claim 1, wherein the second component (9) includes a third surface (9A) facing the second surface (42B) of the PCB (42),
the protrusion (1200) of the first component (71) faces a part of the third surface (9A) of the second component (9) through the opening (1000) of the PCB (42), and
when viewed from above the first surface (42A) of the PCB (42), about two-thirds or more of the opening (1000) of the PCB (42) overlaps with the third surface (9A) of the second component (9).

3. The electronic device (2) of claim 1 or 2, wherein the first component (71) is disposed on the first surface (42A) of the PCB (42) in an unattached state with respect to the PCB (42), and
the second component (9) is surface-mounted on the second surface (42B) of the PCB (42).

4. The electronic device (2) of claims 1 to 3, wherein the first component (71) is disposed on the first surface (42A) of the PCB (42) in an attached state with respect to the PCB (42), and
the second component (9) is surface-mounted on the second surface (42B) of the PCB (42).

5. The electronic device (2) of claims 1 to 4, wherein the opening (1000) of the PCB (42) includes a notch formed at an edge of the PCB (42) when viewed from above the first surface (42A) of the PCB (42).

6. The electronic device (2) of claims 1 to 5, wherein the opening (1000) of the PCB (42) includes a hole located inside the edge of the PCB (42) when viewed from above the first surface (42A) of the PCB (42).

7. The electronic device (2) of claims 1 to 6, wherein the first component (71) is extended from a first portion (7111) not overlapping with the PCB (42) to a second portion (7112) overlapping with the PCB (42) when viewed from above the first surface (42A) of the PCB (42), and
the second portion (7112) of the first component (71) includes the protrusion (1200) inserted into the opening (1000) of the PCB (42).

8. The electronic device (2) of claim 1, further comprising:
a battery (52, 189) located in the electronic device (2),
wherein when viewed from above the first surface (42A) of the PCB (42), the second portion (7112) of the speaker housing (711) is located between the speaker (712) and the battery (52, 189).

9. The electronic device (2) of claim 1, wherein the speaker housing (711) includes a metal plate (1022) that forms at least in part the protrusion (1200) inserted into the opening (1000) of the PCB (42), and
the metal plate (1022) is configured to define a portion of the resonance space of the speaker housing (711).

10. The electronic device (2) of any one of claims 1,8, 9, further comprising:
a display module (26, 160) and a support plate (2211),
wherein the PCB (42) and the speaker module (71) are located between the display module (26, 160) and the support plate (2211),
the first surface (42A) of the PCB (42) faces the display module (26, 160), and
the second surface (42B) of the PCB (42) faces the support plate (2211).

11. The electronic device (2) of any one of claims 1, 8 to 10, wherein the speaker housing (711) includes a first metal plate (1021) and a second metal plate (1022),
the first metal plate (1021) includes a first planar portion (1101) extended from a first region (11011) not overlapping with the PCB (42) to a second region (11012) overlapping with the PCB (42) when viewed from above the first surface (42A) of the PCB (42),
the second metal plate (1022) includes:
a first partial plate region (10221) located between the second region (11012) of the first metal plate (1021) and the first surface (42A) of the PCB (42), and including a second planar portion (1102) facing the first surface (42A) of the PCB (42), and
a second partial plate region (10222) extended from the first partial plate region (10221), and including a third planar portion (1103) facing the second component (9) through the opening (1000) of the PCB (42),
the speaker (712) is located within the speaker housing (711) so as to overlap with the first region (11011) of the first planar portion (1101) when viewed from above the first surface (42A) of the PCB (42),
the first planar portion (1101), the second planar portion (1102), and the third planar portion (1103) define a resonance space of the speaker housing (711), and
a second distance (D2) by which the third planar portion (1103) is spaced from the second region (11012) of the first planar portion (1101) is greater than a first distance (D1) by which the second planar portion (1102) is spaced from the second region (11012) of the first planar portion (1101).

12. The electronic device (2) of any one of claims 1 to 11, wherein the second component (9) includes a socket configured to connect a subscriber identity module SIM, (196) card.

13. The electronic device of any one of claims 1 to 12, wherein the opening (1000) of the PCB (42) is formed in a non-ground area of the PCB (42).

## Patentansprüche

1. Elektronische Vorrichtung (2), umfassend:
eine Leiterplatte, PCB, (42);
eine erste Komponente (71), die auf einer ersten Oberfläche (42A) der PCB (42) angeordnet ist; und
eine zweite Komponente (9), die auf einer zweiten Oberfläche (42B) der PCB (42) angeordnet ist, die in eine entgegengesetzte Richtung zur ersten Oberfläche (42A) weist,
wobei die PCB (42) eine Öffnung (1000) umfasst, die zwischen der ersten Komponente (71) und der zweiten Komponente (9) ausgebildet ist;
**dadurch gekennzeichnet, dass**
die erste Komponente (71) ein Lautsprechermodul ist, das ein Lautsprechergehäuse (711) und einen innerhalb des Lautsprechergehäuses (711) angeordneten Lautsprecher (712) umfasst,
sich das Lautsprechergehäuse (711) von einem ersten Abschnitt (7111), der sich nicht mit der PCB (42) überlappt, bis zu einem zweiten Abschnitt (7112) erstreckt, der sich bei Betrachtung von oben auf die erste Oberfläche (42A) der PCB (42) mit der PCB (42) überlappt,
der Lautsprecher (712) im ersten Abschnitt (7111) des Lautsprechergehäuses (711) angeordnet ist,
der erste Abschnitt (7111) und der zweite Abschnitt (7112) des Lautsprechergehäuses (711) einen Resonanzraum für den Lautsprecher (712) bilden, und
der zweite Abschnitt (7112) des Lautsprechergehäuses (711) einen Vorsprung (1200) umfasst, der so konfiguriert ist, dass er in die Öffnung (1000) der PCB (42) eingeführt ist und der zweiten Komponente (9) zugewandt ist.

2. Elektronische Vorrichtung (2) nach Anspruch 1, wobei die zweite Komponente (9) eine dritte Oberfläche (9A) umfasst, die der zweiten Oberfläche (42B) der PCB (42) zugewandt ist,
der Vorsprung (1200) der ersten Komponente (71) durch die Öffnung (1000) der PCB (42) einem Teil der dritten Oberfläche (9A) der zweiten Komponente (9) zugewandt ist, und
bei Betrachtung von oben auf die erste Oberfläche (42A) der PCB (42) sich etwa zwei Drittel oder mehr der Öffnung (1000) der PCB (42) mit der dritten Oberfläche (9A) der zweiten Komponente (9) überlappen.

3. Elektronische Vorrichtung (2) nach Anspruch 1 oder 2, wobei die erste Komponente (71) auf der ersten Oberfläche (42A) der PCB (42) in einem nicht befestigten Zustand in Bezug auf die PCB (42) angeordnet ist, und
die zweite Komponente (9) auf der zweiten Oberfläche (42B) der PCB (42) oberflächenmontiert ist.

4. Elektronische Vorrichtung (2) nach den Ansprüchen 1 bis 3, wobei die erste Komponente (71) auf der ersten Oberfläche (42A) der PCB (42) in einem befestigten Zustand in Bezug auf die PCB (42) angeordnet ist, und
die zweite Komponente (9) auf der zweiten Oberfläche (42B) der PCB (42) oberflächenmontiert ist.

5. Elektronische Vorrichtung (2) nach den Ansprüchen 1 bis 4, wobei die Öffnung (1000) der PCB (42) eine Kerbe umfasst, die bei Betrachtung von oben auf die erste Oberfläche (42A) der PCB (42) an einer Kante der PCB (42) ausgebildet ist.

6. Elektronische Vorrichtung (2) nach den Ansprüchen 1 bis 5, wobei die Öffnung (1000) der PCB (42) ein Loch umfasst, das sich bei Betrachtung von oben auf die erste Oberfläche (42A) der PCB (42) innerhalb der Kante der PCB (42) befindet.

7. Elektronische Vorrichtung (2) nach den Ansprüchen 1 bis 6, wobei sich die erste Komponente (71) von einem ersten Abschnitt (7111), der sich nicht mit der PCB (42) überlappt, zu einem zweiten Abschnitt (7112) erstreckt, der sich mit der PCB (42) überlappt, wenn man von oben auf die erste Oberfläche (42A) der PCB (42) blickt, und
der zweite Abschnitt (7112) der ersten Komponente (71) den Vorsprung (1200) umfasst, der in die Öffnung (1000) der PCB (42) eingeführt ist.

8. Elektronische Vorrichtung (2) nach Anspruch 1, umfassend ferner:
eine in der elektronischen Vorrichtung (2) angeordnete Batterie (52, 189),
wobei, von oben auf die erste Oberfläche (42A) der PCB (42) betrachtet, der zweite Abschnitt (7112) des Lautsprechergehäuses (711) zwischen dem Lautsprecher (712) und der Batterie (52, 189) angeordnet ist.

9. Elektronische Vorrichtung (2) nach Anspruch 1, wobei das Lautsprechergehäuse (711) eine Metallplatte (1022) umfasst, die zumindest teilweise den Vorsprung (1200) bildet, der in die Öffnung (1000) der PCB (42) eingeführt ist, und
die Metallplatte (1022) dazu konfiguriert ist, einen Abschnitt des Resonanzraums des Lautsprechergehäuses (711) zu definieren.

10. Elektronische Vorrichtung (2) nach einem der Ansprüche 1, 8, 9, umfassend ferner:
ein Anzeigemodul (26, 160) und eine Stützplatte (2211),
wobei die PCB (42) und das Lautsprechermodul (71) zwischen dem Anzeigemodul (26, 160) und der Stützplatte (2211) angeordnet sind,
die erste Oberfläche (42A) der PCB (42) dem Anzeigemodul (26, 160) zugewandt ist und
die zweite Oberfläche (42B) der PCB (42) der Stützplatte (2211) zugewandt ist.

11. Elektronische Vorrichtung (2) nach einem der Ansprüche 1, 8 bis 10, wobei das Lautsprechergehäuse (711) eine erste Metallplatte (1021) und eine zweite Metallplatte (1022) umfasst,
die erste Metallplatte (1021) einen ersten ebenen Abschnitt (1101) umfasst, der sich von einem ersten Bereich (11011), der sich nicht mit der PCB (42) überlappt, bis zu einem zweiten Bereich (11012) erstreckt, der sich bei Betrachtung von oben auf die erste Oberfläche (42A) der PCB (42) mit der PCB (42) überlappt,
die zweite Metallplatte (1022) Folgendes umfasst:
einen ersten Teilplattenbereich (10221), der sich zwischen dem zweiten Bereich (11012) der ersten Metallplatte (1021) und der ersten Oberfläche (42A) der PCB (42) befindet und einen zweiten ebenen Abschnitt (1102) umfasst, der der ersten Oberfläche (42A) der PCB (42) zugewandt ist, und
einen zweiten Teilplattenbereich (10222), der sich vom ersten Teilplattenbereich (10221) erstreckt und einen dritten ebenen Abschnitt (1103) umfasst, der durch die Öffnung (1000) der PCB (42) der zweiten Komponente (9) zugewandt ist,
der Lautsprecher (712) innerhalb des Lautsprechergehäuses (711) so angeordnet ist, dass er sich bei Betrachtung von oben auf die erste Oberfläche (42A) der PCB (42) mit dem ersten Bereich (11011) des ersten ebenen Abschnitts (1101) überlappt,
der erste ebene Abschnitt (1101), der zweite ebene Abschnitt (1102) und der dritte ebene Abschnitt (1103) einen Resonanzraum des Lautsprechergehäuses (711) definieren, und
ein zweiter Abstand (D2), um den der dritte ebene Abschnitt (1103) vom zweiten Bereich (11012) des ersten ebenen Abschnitts (1101) beabstandet ist, größer ist als ein erster Abstand (D1), um den der zweite ebene Abschnitt (1102) vom zweiten Bereich (11012) des ersten ebenen Abschnitts (1101) beabstandet ist.

12. Elektronische Vorrichtung (2) nach einem der Ansprüche 1 bis 11, wobei die zweite Komponente (9) einen Steckplatz umfasst, der zum Anschließen einer Subscriber Identity Module-, SIM, -Karte (196) konfiguriert ist.

13. Elektronische Vorrichtung nach einem der Ansprüche 1 bis 12, wobei die Öffnung (1000) der PCB (42) in einem Nicht-Massebereich der PCB (42) ausgebildet ist.

## Revendications

1. Dispositif électronique (2) comprenant :
une carte de circuit imprimé, PCB, (42) ;
un premier composant (71) disposé sur une première surface (42A) de la PCB (42) ; et
un second composant (9) disposé sur une deuxième surface (42B) de la PCB (42) orientée dans une direction opposée à la première surface (42A),
dans lequel la PCB (42) comporte une ouverture (1000) formée entre le premier composant (71) et le second composant (9) ;
**caractérisé en ce que**
le premier composant (71) est un module de haut-parleur comportant un boîtier de haut-parleur (711) et un haut-parleur (712) situé à l'intérieur du boîtier de haut-parleur (711),
le boîtier de haut-parleur (711) s'étend à partir d'une première partie (7111) non chevauchant la PCB (42) jusqu'à une seconde partie (7112) chevauchant la PCB (42) en observant depuis le dessus de la première surface (42A) de la PCB (42),
le haut-parleur (712) est situé dans la première partie (7111) du boîtier de haut-parleur (711),
la première partie (7111) et la seconde partie (7112) du boîtier de haut-parleur (711) forment un espace de résonance pour le haut-parleur (712), et
la seconde partie (7112) du boîtier de haut-parleur (711) comporte une saillie (1200) configurée pour être insérée dans l'ouverture (1000) de la PCB (42) et faire face au second composant (9).

2. Dispositif électronique (2) selon la revendication 1, dans lequel le second composant (9) comporte une troisième surface (9A) faisant face à la deuxième surface (42B) de la PCB (42),
la saillie (1200) du premier composant (71) fait face à une partie de la troisième surface (9A) du second composant (9) à travers l'ouverture (1000) de la PCB (42), et
en observant depuis le dessus de la première surface (42A) de la PCB (42), environ les deux tiers ou plus de l'ouverture (1000) de la PCB (42) chevauche la troisième surface (9A) du second composant (9).

3. Dispositif électronique (2) selon la revendication 1 ou 2, dans lequel le premier composant (71) est disposé sur la première surface (42A) de la PCB (42) de manière non attachée par rapport à la PCB (42), et
le second composant (9) est monté en surface sur la deuxième surface (42B) de la PCB (42).

4. Dispositif électronique (2) selon les revendications 1 à 3, dans lequel le premier composant (71) est disposé sur la première surface (42A) de la PCB (42) de manière attachée par rapport à la PCB (42), et
le second composant (9) est monté en surface sur la deuxième surface (42B) de la PCB (42).

5. Dispositif électronique (2) selon les revendications 1 à 4, dans lequel l'ouverture (1000) de la PCB (42) comporte une encoche formée à un bord de la PCB (42) en observant depuis le dessus de la première surface (42A) de la PCB (42).

6. Dispositif électronique (2) selon les revendications 1 à 5, dans lequel l'ouverture (1000) de la PCB (42) comporte un trou situé au sein du bord de la PCB (42) en observant depuis le dessus de la première surface (42A) de la PCB (42).

7. Dispositif électronique (2) selon les revendications 1 à 6, dans lequel le premier composant (71) s'étend à partir d'une première partie (7111) non chevauchant la PCB (42) jusqu'à une seconde partie (7112) chevauchant la PCB (42) en observant depuis le dessus de la première surface (42A) de la PCB (42), et
la seconde partie (7112) du premier composant (71) comporte la saillie (1200) insérée dans l'ouverture (1000) de la PCB (42).

8. Dispositif électronique (2) selon la revendication 1, comprenant en outre :
une batterie (52, 189) située dans le dispositif électronique (2),
dans lequel, en observant depuis le dessus de la première surface (42A) de la PCB (42), la seconde partie (7112) du boîtier de haut-parleur (711) est située entre le haut-parleur (712) et la batterie (52, 189).

9. Dispositif électronique (2) selon la revendication 1, dans lequel le boîtier de haut-parleur (711) comporte une plaque métallique (1022) qui forme au moins en partie la saillie (1200) insérée dans l'ouverture (1000) de la PCB (42), et
la plaque métallique (1022) est configurée pour définir une partie de l'espace de résonance du boîtier de haut-parleur (711).

10. Dispositif électronique (2) selon l'une quelconque des revendications 1, 8, 9, comprenant en outre :
un module d'affichage (26, 160) et une plaque de support (2211),
dans lequel la PCB (42) et le module de haut-parleur (71) sont situés entre le module d'affichage (26, 160) et la plaque de support (2211),
la première surface (42A) de la PCB (42) fait face au module d'affichage (26, 160), et
la deuxième surface (42B) de la PCB (42) fait face à la plaque de support (2211).

11. Dispositif électronique (2) selon l'une quelconque des revendications 1, 8 à 10, dans lequel le boîtier de haut-parleur (711) comporte une première plaque métallique (1021) et une deuxième plaque métallique (1022),
la première plaque métallique (1021) comporte une première partie plane (1101) s'étendant à partir d'une première région (11011) non chevauchant la PCB (42) jusqu'à une seconde région (11012) chevauchant la PCB (42) en observant depuis le dessus de la première surface (42A) de la PCB (42),
la deuxième plaque métallique (1022) comporte :
une première région de plaque partielle (10221) située entre la seconde région (11012) de la première plaque métallique (1021) et la première surface (42A) de la PCB (42), et comportant une deuxième partie plane (1102) faisant face à la première surface (42A) de la PCB (42), et
une seconde région de plaque partielle (10222) s'étendant à partir de la première région de plaque partielle (10221), et comportant une troisième partie plane (1103) faisant face au second composant (9) à travers l'ouverture (1000) de la PCB (42),
le haut-parleur (712) est situé à l'intérieur du boîtier de haut-parleur (711) de manière à chevaucher la première région (11011) de la première partie plane (1101) en observant depuis le dessus de la première surface (42A) de la PCB (42),
la première partie plane (1101), la deuxième partie plane (1102) et la troisième partie plane (1103) définissent un espace de résonance du boîtier de haut-parleur (711), et
une seconde distance (D2) par laquelle la troisième partie plane (1103) est espacée de la seconde région (11012) de la première partie plane (1101) est supérieure à une première distance (D1) par laquelle la deuxième partie plane (1102) est espacée de la seconde région (11012) de la première partie plane (1101).

12. Dispositif électronique (2) selon l'une quelconque des revendications 1 à 11, dans lequel le second composant (9) comporte une prise configurée pour se connecter à une carte de module d'identité d'abonné SIM (196).

13. Dispositif électronique selon l'une quelconque des revendications 1 à 12, dans lequel l'ouverture (1000) de la PCB (42) est formée dans une zone non mise à la terre de la PCB (42).
